Europäisches Patentamt

European Patent Office

Office européen des brevets

(11) Numéro de publication: **0 263 745 B1**

# FASCICULE DE BREVET EUROPEEN

(45) Date de publication de fascicule du brevet: **20.01.93**  (51) Int. Cl.⁵: **G01R  23/02**

(21) Numéro de dépôt: **87402175.1**

(22) Date de dépôt: **30.09.87**

(54) **Procédé et dispositif de mesure de la fréquence d'un signal électrique.**

(30) Priorité: **01.10.86 FR 8613691**

(43) Date de publication de la demande:
**13.04.88 Bulletin  88/15**

(45) Mention de la délivrance du brevet:
**20.01.93 Bulletin  93/03**

(84) Etats contractants désignés:
**DE ES GB IT**

(56) Documents cités:
**US-A- 3 518 540**
**US-A- 3 710 262**

**TOUTE L'ELECTRONIOUE, no. 456, août-septembre 1980, pages 71-74, Paris, FR; L. CHATAIGNIER: "Philips: les fréquencemètres à haute résolution PM 6667/68"**

**ELEKTRONIK, vol. 33, no. 25, décembre 1984, pages 67-69, Munich, DE; M. NOWAK: "Messgerät für Frequenzen von 0,0005 Hz...500 kHz"**

(73) Titulaire: **JAEGER**
**2, rue Baudin**
**F-92303 Levallois-Perret(FR)**

(72) Inventeur: **Laugier, Philippe**
**12 rue de Verdun**
**F-92600 Asnieres(FR)**

(74) Mandataire: **Martin, Jean-Jacques et al**
**Cabinet REGIMBEAU 26, Avenue Kléber**
**F-75116 Paris(FR)**

**Description**

La présente invention concerne un procédé et un dispositif de mesure de la fréquence d'un signal électrique.

Un premier but de la présente invention est de permettre de mesurer la fréquence d'un signal susceptible d'évoluer dans une large gamme de fréquences, par exemple de l'ordre de 2 Hz à 20KHz.

Un autre but de la présente invention est de proposer un procédé et un dispositif de mesure de fréquence évoluant dans une large gamme avec une précision au moins égale à un pour cent, en un temps ne dépassant pas 0,5s.

Un autre but de la présente invention est de proposer un procédé et un dispositif permettant de mesurer une fréquence qui n'est pas stable dans le temps.

Mesurer une fréquence peut se faire de deux façons : soit en fréquencemètre, soit en périodemètre

Le fonctionnement en fréquencemètre consiste à mesurer la fréquence d'un signal en comptant le nombre d'impulsions ou de basculement de même sens du signal pendant un temps unitaire déterminé. Cette technique de mesure ne donne cependant pas satisfaction lorsqu'il s'agit de mesurer avec une bonne précision une fréquence relativement basse, du fait que cette technique demande un temps de mesure très long. A titre d'exemple, pour mesurer une fréquence de l'ordre de 2 Hz avec une précision de 1%, selon la technique de fréquencemètre, il faut compter 100 périodes de signal, ce qui requiert un temps de mesure de 50 secondes.

Le fonctionnement en périodemètre consiste à mesurer la période du signal en comptant le nombre d'impulsions d'une horloge contenues dans une période du signal. Cette technique de mesure ne donne néanmoins pas satisfaction lorsqu'il s'agit de mesurer, avec une bonne précision, une fréquence relativement élevée, du fait que cette technique de mesure demande alors une horloge de fréquence très rapide. A titre d'exemple, pour mesurer une fréquence de l'ordre de 20 KHz ou plus précisément une période de 50$\mu$s avec une précision de 1%, selon la technique de périodemètre, il faut disposer d'une horloge de 2MHz. Par ailleurs, pour obtenir la fréquence du signal, après mesure du type périodemètre, il est nécessaire d'effectuer une division pour convertir la période mesurée en fréquence.

Les techniques de mesure du type fréquencemètre et périodemètre ne permettent donc pas de remplir les buts de la présente invention précisés précédemment.

Le document TOUTE L'ELECTRONIQUE, n° 456 (1980), pages 71-74 ; L. CHATAIGNIER : "Philips" : Les fréquences mètres à haute résolution PM6667/68, décrit un fréquencemètre à microprocesseur qui fait une mesure de rapport de fréquences en comparant la fréquence d'un signal d'entrée avec une fréquence de référence interne.

Le fréquencemètre représenté sur la figure 2 de ce document comprend :
- une base de temps à 10MHz,
- une porte de mise en forme du signal d'entrée,
- un microprocesseur qui définit un temps de mesure,
- une porte de synchronisme qui reçoit le signal d'entrée en provenance de la porte de mise en forme et le signal représentant le temps de mesure,
- une porte principale de type NAND qui reçoit sur ses entrées le signal d'entrée en provenance de la porte de mise en forme et le signal de sortie de la porte de synchronisme,
- une porte secondaire de type NAND qui reçoit sur ses entrées le signal de sortie de la porte de synchronisme et le signal d'horloge de la base de temps,
- un compteur d'évènements qui compte le nombre d'impulsions du signal issu de la porte principale, et
- un compteur de temps qui compte le nombre d'impulsions du signal issu de la porte secondaire.

Le fonctionnement de ce fréquencemètre est le suivant.

Le microprocesseur définit un temps de mesure de durée fixe prédéterminée.

La porte de synchronisme détecte le premier cycle du signal d'entrée qui se présente tout de suite après le début du temps de mesure et déclenche l'ouverture de la porte principale et de la porte secondaire lors de cette détection.

De plus, la porte de synchronisme détecte également le premier cycle du signal d'entrée qui se présente tout de suite après la fin du temps de mesure et déclenche la fermeture de la porte principale et de la porte secondaire, lors de cette détection.

L'ouverture et la fermeture de la porte principale et de la porte secondaire sont définies par un signal appelé "commande de porte". Ce signal "commande de porte" est par conséquent synchronisé sur le signal d'entrée. Sa durée n'est pas fixe et prédéterminée mais correspond à un multiple de la période du signal d'entrée.

La mesure de la fréquence est obtenue en divisant le nombre d'impulsions contenues dans le compteur d'évènements par le nombre d'impulsions contenues dans le compteur de temps.

Le fréquencemètre décrit dans le document précité ne fonctionne correctement que pour un temps de mesure supérieur à la période du signal à mesurer. En effet, le fréquencemètre décrit dans ce document ne fonctionne pas si le début d'un cycle du signal d'entrée n'intervient pas pendant le temps de mesure.

Les buts précités sont atteints grâce à un procédé de mesure qui comprend, de façon comparable au document Toute l'Electronique, les étapes qui consistent à :

i) définir un temps de mesure de durée fixe prédéterminée,

ii) détecter les fronts d'un sens donné, montant ou descendant, du signal à mesurer, et générer des signaux de commande de porte synchronisés d'une part sur le premier front de sens donné du signal pendant le temps de mesure, et synchronisés d'autre part sur le premier front de sens donné du signal consécutif à l'échéance du temps de mesure,

iii) compter le nombre de fronts de sens donné du signal entre le premier front du sens donné du signal pendant le temps de mesure et le premier front de sens donné du signal consécutif à l'échéance du temps de mesure,

iv) fournir un signal d'horloge de fréquence constante,

v) compter le nombre d'impulsions d'horloge générées entre le premier front de sens donné du signal pendant le temps de mesure et le premier front de sens donné du signal consécutif à l'échéance du temps de mesure, et,

vi) déterminer le rapport entre d'une part, le nombre de fronts du signal comptés par le premier compteur et d'autre part, le nombre d'impulsions d'horloge comptées par le second compteur,

Ce procédé étant caractérisé selon la présente invention par le fait que la détection des fronts du signal d'entrée est exploitée pour synchroniser l'origine du temps de mesure sur un premier front de sens donné du signal.

Cette nouvelle technique de mesure sera explicitée dans le détail par la suite.

On notera néanmoins dès à présent qu'elle permet de mesurer la fréquence d'un signal comprise entre 2Hz et 20KHz, avec une précision au moins égale à un pour cent, en un temps ne dépassant pas 0,5s.

Selon une autre caractéristique avantageuse de la présente invention, la période du signal d'horloge est environ 100 fois plus faible que la durée du temps.

Selon une autre caractéristique avantageuse la durée du temps de mesure est comprise entre 40 et 200 ms en étant de préférence de l'ordre de 50 msec.

De préférence, selon l'invention, la fréquence du signal est obtenue en multipliant par la fréquence du signal d'horloge, le résultat du rapport entre d'une part, le nombre de fronts du signal calculé à l'étape iii) et d'autre part, le nombre d'impulsions d'horloge calculé à l'étape v).

La présente invention concerne également un dispositif de mesure de la fréquence d'un signal électrique pour la mise en oeuvre du procédé précité.

Ce dispositif comprend, de façon comparable au document précité "Toute l'Electronique" :

- un ensemble qui définit un temps de mesure de durée fixe prédéterminée,

- des moyens de détection qui détectent les fronts d'un sens donné, montant ou descendant, du signal pour générer des signaux de commande de porte synchronisés d'une part sur le premier front de sens donné du signal pendant le temps de mesure et synchronisés d'autre part sur le premier front de sens donné du signal consécutif à l'échéance du temps de mesure,

- un premier compteur piloté par les signaux de commande de porte et qui compte le nombre N de fronts de sens donné du signal entre le premier front de sens donné du signal pendant le temps de mesure et le premier front de sens donné du signal consécutif à l'échéance du temps de mesure,

- une horloge qui délivre un signal d'horloge He de fréquence constante,

- un second compteur piloté par les signaux de commande de porte et qui compte le nombre d'impulsions d'horloge générés entre le premier front de sens donné du signal pendant le temps de mesure et le premier front de sens donné du signal consécutif à l'échéance du temps de mesure, et

- une cellule apte à déterminer le rapport entre, d'une part, le nombre N de fronts du signal comptés par le premier compteur et d'autre part, le nombre d'impulsions K d'horloge comptées par le second compteur.

Cependant, par rapport au fréquencemètre décrit dans le document "Toute l'Electronique", le dispositif conforme à l'invention se distingue par le fait que les moyens de détection qui détectent les fronts du signal sont reliés à l'ensemble qui définit le temps de mesure de durée fixe prédéterminée et agissent sur cet ensemble pour synchroniser l'origine du temps de mesure Tf sur un premier front de sens donné du signal.

D'autres caractéristiques, buts et avantages de la présente invention apparaîtront à la lecture de la description détaillée qui va suivre et en regard des dessins annexés donnés à titre d'exemple non limitatif et sur lesquels :

- les figures 1 et 1bis représentent des chronogrammes de signaux explicitant le fonctionnement du dispositif de mesure conforme à la présente invention,

- la figure 2 représente schématiquement la réponse du dispositif de mesure de la fréquence conforme à la présente invention, à une brusque variation de fréquence du signal d'entrée, pour diverses valeurs de la durée de la fenêtre de mesure,
- la figure 3 représente un schéma général du dispositif de mesure conforme à la présente invention,
- la figure 4 illustre un sous-ensemble de ce dispositif adapté pour le calcul de grandeurs représentatives de la fréquence,
- la figure 5 représente un autre sous-ensemble du dispositif conforme à la présente invention , servant de circuit de multiplexage,
- la figure 6 représente un autre sous-ensemble du dispositif de mesure conforme à la présente invention, servant de circuit de gestion,
- la figure 7 représente un autre sous-ensemble du dispositif de mesure conforme à la présente invention, servant de circuit de sortie.
- les figures 8A et 8B représentent un organigramme illustrant le fonctionnement d'un sous-ensemble de division conforme à la présente invention,
- les figures 9 et 10 illustrent ce sous-ensemble de division.

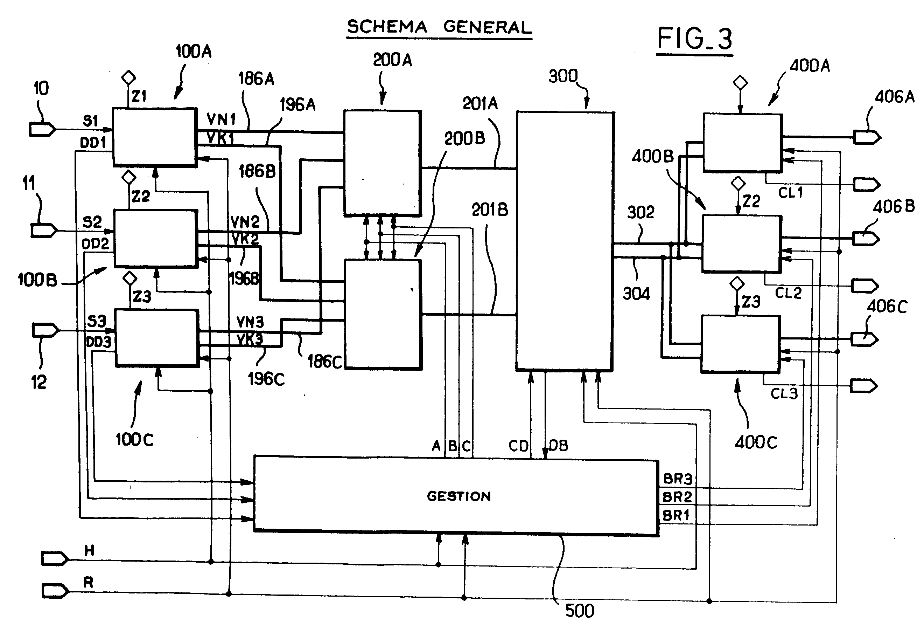

Le dispositif illustré schématiquement sur la figure 3 est adapté pour mesurer la fréquence respective de trois signaux électriques appliqués respectivement sur les entrées principales 10, 11 et 12 du dispositif.

Pour l'essentiel le dispositif illustré sur la figure 3 comprend trois modules de calcul 100A, 100B, 100C, deux modules de multiplexage 200A, 200B, un module de division 300, trois modules de sortie 400A, 400B et 400C et un module de gestion 500.

Les modules de calcul 100A, 100B et 100C sont adaptés pour calculer des grandeurs N et K, qui seront explicitées par la suite, représentatives respectivement de la fréquence des signaux appliqués sur les entrées 10, 11 et 12.

Le module 200A assure le multiplexage séquentiel des paramètres N précités issus des modules 100A, 100B et 100C. De façon similaire, le module 200B assure le multiplexage des paramètres K issus des modules 100A, 100B et 100C.

Le module de division 300 calcule le rapport entre les paramètres N et K précités.

Les modules de sortie 400A, 400B et 400C ont pour but de mémoriser le résultat du calcul issu du module diviseur 300, correspondant respectivement aux signaux appliqués sur les entrées 10, 11 et 12.

Enfin, le module de gestion 500 a pour but de synchroniser le fonctionnement général des modules précités 100, 200, 300 et 400.

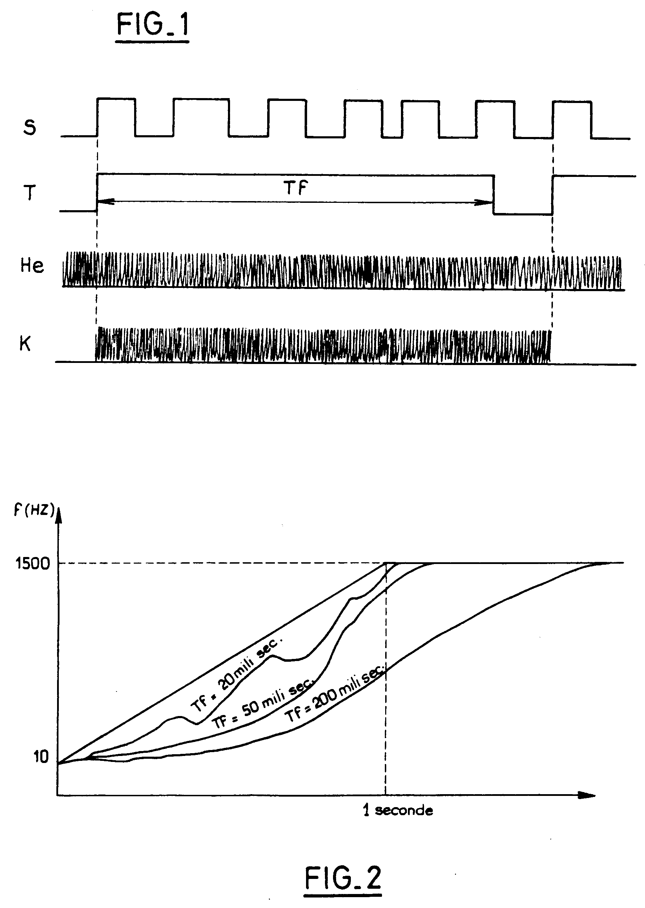

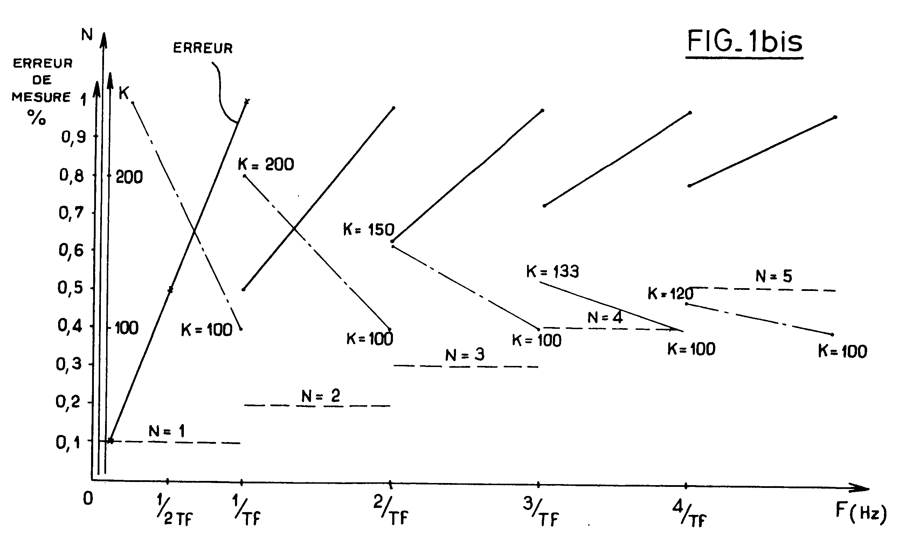

On va dans un premier temps expliciter le procédé de mesure conforme à la présente invention, en regard de la figure 1.

La première ligne de cette figure illustre schématiquement un signal logique S dont on souhaite mesurer la fréquence.

La deuxième ligne de la figure 1 illustre schématiquement un signal T dont les échelons définissent des fenêtres de mesure Tf de durée déterminée.

Enfin, la troisième ligne de la figure 1 illustre un signal d'horloge He de fréquence constante Fe.

Pour éliminer les inconvénients des techniques de mesure du type fréquencemètre et/ou périodemètre précitées, le procédé de mesure conforme à la présente invention consiste à compter le nombre N de fronts d'un sens donné, par exemple, le nombre de fronts montants, du signal S pendant la fenêtre de mesure Tf, à compter le nombre K d'impulsions d'horloge générées entre la détection du premier front de sens donné (par exemple le premier front montant) du signal S pendant la fenêtre de mesure Tf, et l'apparition du premier front de même sens consécutif à l'échéance de la fenêtre de mesure Tf, puis à faire le rapport entre d'une part, le nombre N de fronts du signal S calculé pendant la fenêtre de mesure Tf et d'autre part, le nombre K d'impulsions d'horloge.

On a illustré schématiquement sur la quatrième ligne de la figure 1 le nombre K d'impulsions d'horloge calculé entre la détection du premier front de sens donné du signal pendant la fenêtre de mesure Tf et l'apparition du premier front de même sens consécutif à l'échéance de la fenêtre de mesure Tf.

Le résultat du rapport entre les nombres N et K est directement représentatif de la fréquence recherchée du signal S.

En effet, la fréquence Fs du signal est déterminée par la relation : $Fs = (N/K)Fe$.

En d'autres termes, il suffit de multiplier le résultat du rapport N/K par la fréquence du signal d'horloge pour obtenir la fréquence recherchée du signal.

L'erreur réalisée sur la mesure est égale au plus à une impulsion d'horloge sur K impulsions d'horloge comptabilisées.

De ce fait, l'erreur de la mesure est maximale lorsque la période du signal correspond sensiblement à la durée de la fenêtre de mesure Tf. Dans cas, N = 1 et l'erreur de mesure est égale à 1/K, K étant égal au nombre d'impulsions d'horloge compté pendant la fenêtre Tf.

Comme indiqué précédemment, on veut une précision de mesure au moins égale à 1%.

Il en résulte que 1/K doit être égal à 1/100 soit, K = 100. En d'autres termes, la période du signal d'horloge He doit être 100 fois inférieure à la durée de la fenêtre de mesure Tf.

Sur la figure 1bis annexée, on a illustré schématiquement l'erreur de mesure sur la fréquence, en pour cent, en fonction de la fréquence du signal d'entrée.

La figure 1bis correspond au cas précité où la période du signal d'horloge He est 100 fois plus courte que la durée de la fenêtre de mesure Tf.

Comme indiqué précédemment, l'erreur est maximale et égale à 1% lorsque la période du signal est égale à la durée de la fenêtre de mesure Tf.

Lorsque la fréquence du signal à mesurer diminue à partir de cette valeur 1/Tf, le nombre N reste égal à 1, mais le nombre K d'impulsions d'horloge comptabilisées croît proportionnellement à la réduction de fréquence. En conséquence, lorsque la fréquence à mesurer décroît à partir de la valeur 1/Tf, l'erreur de mesure décroît proportionnellement comme illustré sur la figure 1 bis.

Par contre, lorsque la fréquence à mesurer augmente à partir de la fréquence 1/Tf, le nombre N croît progressivement, par pas réguliers, correspondant aux multiples 1/Tf comme illustré sur la figure 1bis, et pour chacun des pas de croissance du nombre N, le nombre K d'impulsions d'horloge comptabilisées, décroît entre N.100/(N - 1) et 100.

En conséquence, lorsque la fréquence à mesurer croît progressivement à partir de la valeur 1/Tf, l'erreur de mesure est définie par une suite d'escaliers croissants discontinus, dont la pente diminue et qui plafonnent à 1 % comme illustré sur la figure 1 bis.

L'évaluation de l'erreur de mesure illustrée sur la figure 1bis n'est valable qu'en statique.

On a illustré sur la figure 2 l'allure de la réponse du dispositif de mesure conforme à la présente invention à une brusque variation de fréquence en entrée. Plus précisément, on a illustré sur la figure 2 la réponse du dispositif pour différentes valeurs de la durée de la fenêtre de mesure Tf. La représentation dela figure 2 résulte d'une simulation effectuée par calcul. Cette simulation montre que l'erreur dynamique est la plus faible quant la fenêtre Tf est la plus petite possible. Cependant, cette simulation a montré que si l'on prend une fenêtre inférieure à 50ms la réponse n'est plus monotone, on voit apparaître des oscillations. Ces oscillations ne sont pas admissibles dans la mesure où elles se répercuteraient sur l'organe de visualisation en sortie.

Pour cette raison, la demanderesse a déterminé que le temps de mesure Tf optimum est situé aux alentours de 50ms.

Pour tenir compte du rapport précité entre la durée de la fenêtre de mesure Tf et la période du signal d'horloge, rapport égal à 100, la demanderesse a également déterminé que la période du signal d'horloge optimum était de l'ordre de 500$\mu$s.

Dans la pratique, pour mettre en oeuvre un mode de réalisation qui a jsuqu'ici donné satisfaction, la Demanderesse a choisi une durée de fenêtre de mesure Tf égale à 48,8 ms et une période du signal d'horloge égale à 488 $\mu$s, valeur déterminée par $1/2^{11}$.

D'une façon générale, la structure des modules 100A, 100B et 100C est identique.

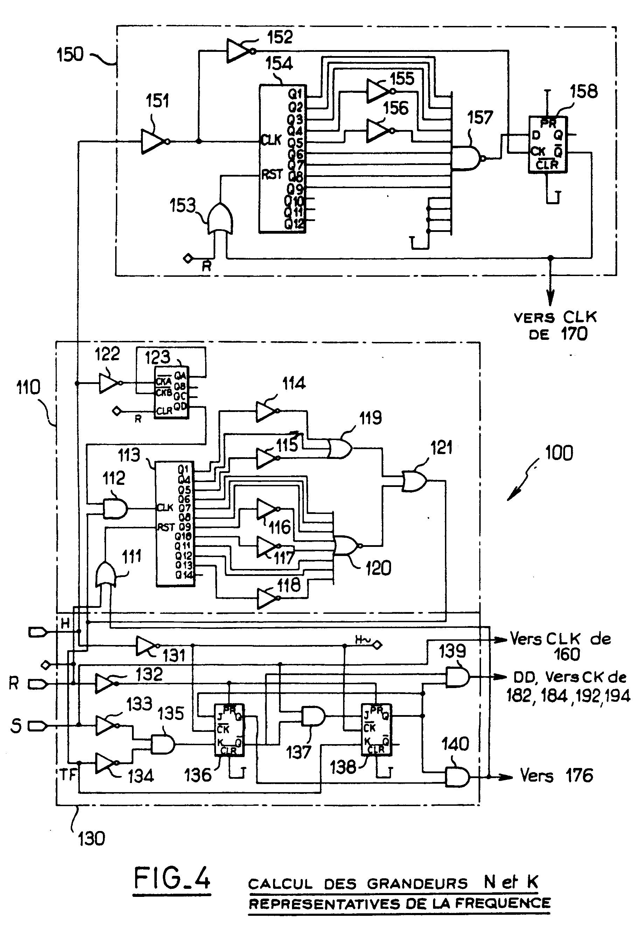

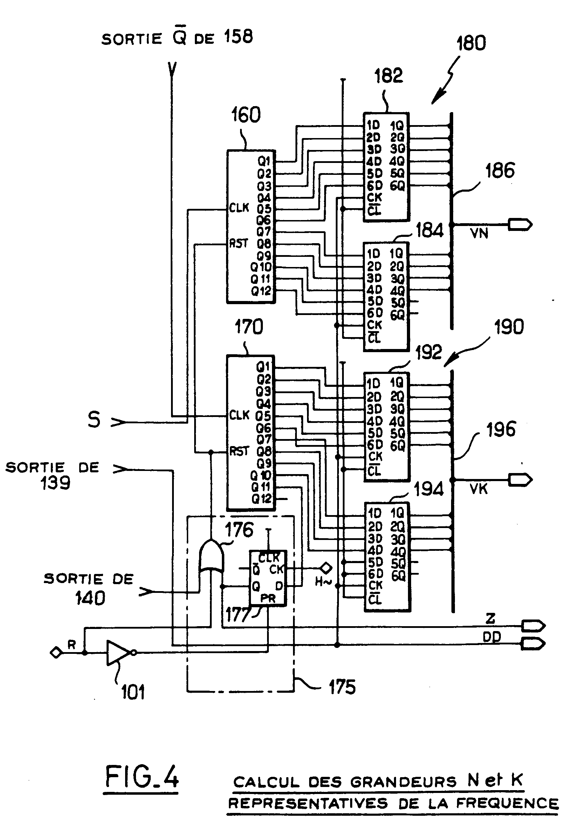

Comme illustré sur la figure 4, ces modules 100 reçoivent en entrée le signal S dont on désire mesurer la fréquence, un signal de cadencement de base H, un signal de remise à zéro général R. Le circuit 100 délivre en sortie un signal multibits Vn représentant le nombre N de périodes du signal comptées pendant la fenêtre de mesure Tf, un signal multibits VK représentant la valeur du nombre K d'impulsions d'horloge comptabilisées entre l'apparition du premier front montant du signal pendant la fenêtre de mesure et le premier front montant du signal consécutif à l'échéance de la fenêtre de mesure, un signal Z indiquant que la fréquence du signal à mesurer est inférieure à une fréquence prédéterminée et que dans ces conditions le résultat de la mesure est nul, et enfin un signal DD adressé au module de gestion 500 et indiquant l'apparition d'un nouveau résultat de mesure, afin d'initier le calcul du rapport N/K correspondant.

Pour l'essentiel, le circuit 100 illustré sur la figure 4 comprend un sous-ensemble 110 qui a pour but de déterminer la durée de fenêtre de mesure Tf, un sous-ensemble de temps qui délivre le signal d'horloge He, deux compteurs 160, 170 qui ont pour but de déterminer respectivement les nombres N et K, un sous-ensemble 175 qui détecte une fréquence inférieure à la fréquence minimale à mesurer, et des portes de sortie 180, 190 associées respectivement aux compteurs 160 et 170 pour mémoriser les nombres N et K.

Le sous-ensemble 110 qui a pour but de déterminer la durée de la fenêtre de mesure Tf reçoit en entrée le signal de cadencement H, le signal de remise à zéro générale R et un signal de remise à zéro auxiliaire généré par le module de synthèse 130 comme cela sera décroit par la suite.

Le signal de cadencement H est de préférence 1MHz. Ce signal de cadencement H est appliqué à l'entrée d'un inverseur 122 dont la sortie attaque l'entrée d'horloge $\overline{CKA}$ d'un compteur 123.

La sortie QA de ce compteur 123 est rebouclée sur l'entrée d'horloge $\overline{CKB}$ du compteur 123. Ce dernier reçoit sur son entrée de remise à zéro CLR le signal de remise à zéro générale R. Les entrées d'une porte ET à deux entrées 112 sont reliées respectivement à la sortie QD du compteur 123 et à la sortie du sous-ensemble 110 composée par la sortie d'une porte OU 121. La sortie de la porte ET 112 attaque l'entrée d'horloge CLK d'un compteur 113. L'entrée de remise à zéro RST de ce compteur 113 est reliée à la sortie d'une porte OU 111. Les entrées de cette dernière sont reliées respectivement à l'entrée de remise à zéro générale R et à la sortie de remise à zéro du sous-ensemble 130 de synthèse, formée par la sortie d'une porte ET 140.

Les sorties Q1 à Q13 du compteur 113 sont reliées aux entrées d'une porte OU 121 par l'intermédiaire de 5 inverseurs 114, 115, 116, 117, 118, une porte OU 119 à trois entrées et une port NOR 120.

Les sorties Q1, Q5, Q9, Q10 et Q13 du compteur 113 sont reliées respectivement aux entrées des inverseurs 114, 115, 116, 117 et 118. Les entrées de la porte OU 119 sont reliées respectivement aux sorties des inverseurs 114 et 115 et à la sortie Q4 du compteur 113.

Les entrées de la porte NOR 13 sont reliées respectivement aux sorties Q6, Q7, Q8, Q11 et Q12 du compteur 113 et aux sorties des inverseurs 116, 117 et 118. Les entrées de la porte OU 121 sont reliées respectivement à la sortie de la porte OU 119 et de la porte NOR 120.

Dans l'hypothèse où le signal de cadencement H présente une fréquence de 1MHz, la porte OU 121 génère en sortie des tops de 2$\mu$s de durée avec une période de 48,8ms. La duree des tops de 2$\mu$s est définie par le compteur 123. La période de 48,8 ms des tops issus de la porte OU 121 est déterminée par le comptage du compteur 113.

La période des tops issus de la porte OU 121 correspond à la durée de la fenêtre de mesure Rf recherché.

Le module de synthèse 130 a pour but de générer en sortie deux signaux destinés respectivement à commander le stockage des valeurs N et K dans les tampons de sortie 180, 190 d'une part, et à réinitialiser les compteurs 160, 170 et réinitialiser le sous-ensemble 110 d'autre part.

Le sous-ensemble 130 reçoit en entrée le signal de cadencement H, le signal de remise à zéro générale R, le signal S dont on souhaite mesurer la fréquence, et le signal Tf généré en sortie de la porte OU 121 précitée.

Le signal de cadencement H est appliqué à l'entrée d'un inverseur 131.

Le signal de remise à zéro générale R est appliqué à l'entrée d'un inverseur 132 dont la sortie attaque des entrées $\overline{PR}$ de deux bascules 136, 138 du type JK montées en cascade.

Le signal S est appliqué à l'entrée d'un inverseur 133. Le signal Tf issu de la porte OU 121 est appliqué à l'entrée d'un inverseur 134.

Les entrées d'une porte ET 135 a deux entrées sont reliées respectivement aux sorties des deux inverseurs 133 et 134 précités. La sortie de la porte ET 135 attaque l'entrée K de la bascule 136. L'entrée d'horloge $\overline{CK}$ de cette bascule 136 est reliée à la sortie de l'inverseur 131. L'entrée J de la bascule 136 est reliée à la sortie Q de la bascule 138. L'entrée de remise à zéro $\overline{CLR}$ de la bascule 136 est reliée à une tension d'alimentation positive +Vcc.

La sortie Q de la bascule 136 attaque une première entrée d'une porte ET 140. La seconde entrée de cette porte ET 140 est réliée à la sortie Q de la bascule 138.

La sortie $\overline{Q}$ de la bascule 136 est reliée à une première entrée d'une porte ET 137 dont la seconde entrée reçoit le signal S dont on souhaite mesurer la fréquence. La sortie de la porte ET 137 est reliée à l'entrée J de la bascule 138.

L'entrée d'horloge $\overline{CK}$ de la bascule 138 est reliée à la sortie de l'inverseur 131. L'entrée K de la bascule 138 reçoit le signal Tf issu de la porte OU 121. L'entrée de remise à zéro $\overline{CLR}$ de la bascule 138 est reliée à une tension d'alimentation positive +Vcc.

La sortie Q de la bascule 138 attaque outre l'entrée J de la bascule 136, une première entrée de la porte ET 139 dont la seconde entrée est reliée à la sortie $\overline{Q}$ de la bascule 136.

Ainsi, la sortie de la porte ET 139 génère une impulsion coïncidant avec la détection du premier front montant du signal concécutif à la fenêtre de mesure Tf pour commander le stockage des valeurs N et K définies par les compteurs 160 et 170 dans les tampons de sortie 180 et 190. La sortie de la porte 140 génère quant à elle une impulsion coïncidant avec le début de la fenêtre de mesure Tf pour réinitialiser les compteurs 160 et 170 et réinitialiser le sous-ensemble 110.

Le sous-ensemble 150 a pour but de diviser la fréquence du signal de cadencement H pour obtenir le signal d'horloge He précité.

Pour cela le signal du cadencement H est appliqué à l'entrée d'un inverseur 151 dont la sortie attaque l'entrée d'horloge CLK d'un compteur 154.

L'entrée de remise à zéro RST du compteur 154 est reliée à la sortie d'une porte OU 153. Celle-ci reçoit en entrée d'une part, le signal de remise à zéro générale R et le signal issu de la sortie $\overline{Q}$ d'une bascule D 158.

L'entrée d'horloge CK de la bascule 158 est reliée par l'intermédiaire d'un inverseur 152 à la sortie de l'inverseur 151.

Les entrées $\overline{PR}$ et $\overline{CLR}$ de la bascule 158 sont reliées à une tension d'alimentation positive +Vcc.

L'entrée D de la bascule 158 est reliée par l'intermédiaire d'une porte NAND 157 et de deux inverseurs 155 et 156 aux sorties Q1 à Q9 de la bascule 154.

Plus précisément, les sorties Q4 et Q5 du compteur 154 sont reliées aux entrées des inverseurs 155 et 156 respectivement.

Les entrées de la porte NAND157 sont reliées aux entrées Q1 à Q3 et Q6 à Q9 du compteur 154 et aux sorties des inverseurs 155 et 156.

Ainsi, le compteur 154 est agencé pour compter 488 impulsions du signal de cadencement H et de ce fait la sortie $\overline{Q}$ de la bascule 158 génère des impulsions d'une durée de 1μs avec une période de 488 μs . Ce signal correspond au signal d'horloge He recherché.

Le compteur 160 compte le nombre de périodes du signal S contenu dans la fenêtre de mesure Tf.

Pour cela le compteur 160 reçoit sur son entrée d'horloge $\overline{CLK}$ le signal S et sur son entrée de remise à zéro RST le signal issu d'une porte OU 176 commandée par le module 130 et plus précisément par la sortie de la porte ET 140 précitée.

Le nombre N disponible en sortie du compteur 160 est mémorisé dans deux tampons 182, 184 formés par exemple chacun de dix bascules D montées en parallèle. Les sorties des bascules 182 et 184 sont reliées à un bus de sortie 186, par exemple un bus à 10 bits. La mémorisation du nombre N déterminé par le compteur 160, dans les bascules 182, 184 est commandée par le signal issu de la porte ET 139 appliqué sur les entrées d'horloge CK des bascules 182 et 184.

De façon généralement similaire le compteur 170 compte le nombre d'impulsions d'horloge He contenues entre le premier front montant du signal pendant la fenêtre de mesure Tf et le premier front montant du signal consécutif à l'échéance de la fenêtre de mesure Tf.

Pour cela, le compteur 170 reçoit sur son entrée d'horloge CLK le signal d'horloge He issu de la sortie $\overline{Q}$ de la bascule 158. L'entrée de remise à zéro RST du compteur 170 est reliée à la sortie de la porte OU 176 précitée.

Les sorties du compteur 170 sont reliées aux entrées de bascules D regroupées par exemple sous forme de deux circuits 192 et 194 dont les sorties sont reliées à un second bus de sortie 196 multibits, par exemple à 10 bits. Le nombre K d'impulsions d'horloge He comptabilisées par le compteur 170 est disponible sur le bus 196. La mémorisation du nombre K dans les bascules D 192 et 194 est commandée par le signal d'horloge issu de la porte ET 139 appliqué sur les entrées d'horloge CK des circuits 192 et 194.

Le module 175 destiné à détecter que la fréquence à mesurer est inférieure à une fréquence prédéterminée est composé de la porte OU 176 précitée et d'une bascule D 177.

L'entrée D de cette dernière est reliée à la sortie Q 11 du compteur 170. En effet, le passage à "1" de la sortie Q11 du compteur 170 signifie que le compteur 170 a dépassé une valeur prédéterminée correspondant à une fréquence de mesure inférieure à 2Hz.

L'entrée d'horloge CK de la bascule 177 est reliée à la sortie de l'inverseur 131. L'entrée $\overline{PR}$ de la bascule 177 et reliée à la sortie d'un inverseur 101 qui reçoit en entrée le signal de remise à zéro générale R. La sortie Q de la bascule 177 est reliée à une entrée de la porte OU 176. Celle-ci reçoit sur ses autres entrées le signal de remise à zéro générale R et la sortie de la porte ET 140.

Le signal Z indiquant que le résultat de la mesure est nulle car la fréquence est inférieure à une fréquence minimale de mesure est disponible sur la sortie Q de la bascule 177. Le signal DD indiquant que le résultat d'une nouvelle mesure est disponible en vue d'une division est généré sur la sortie de la porte ET 139.

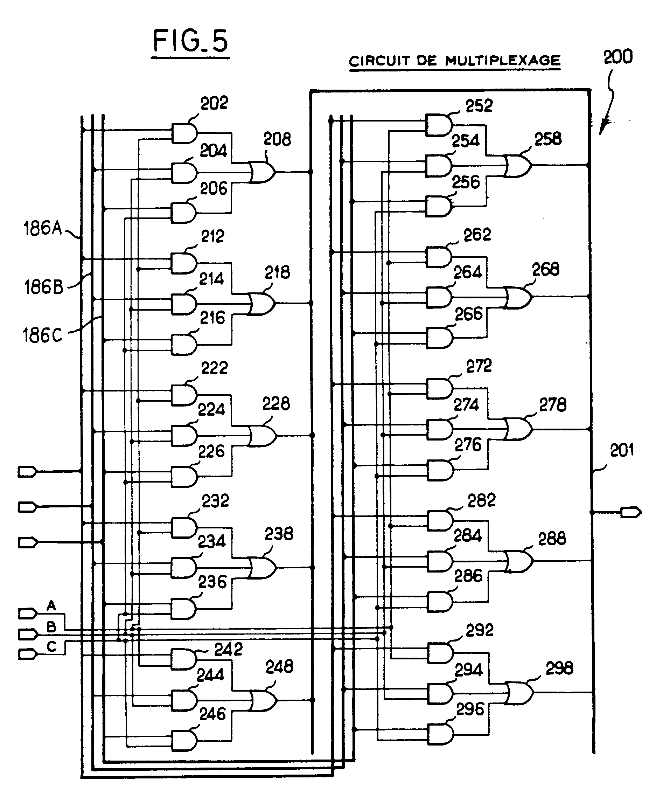

Comme illustré sur la figure 5, les nombres N générés par chacun des circuits 100A, 100B et 100C et disponibles sur les bus de sortie 186A, 186B et 186C, sont multiplexés par des signaux A, B, C issus du circuit de gestion 500.

De façon similaire, les nombres K générés par chacun des sous-ensembles 100A, 100B et 100C et disponibles sur les bus de sortie 196A, 196B et 196C sont multiplexés par le sous-ensemble 200B à l'aide des mêmes signaux A, B et C générés par le module de gestion 500.

De préférence, les sous-ensembles de multiplexage 200A et 200B sont identiques.

On va décrire un exemple de réalisation de ce circuit de multiplexage en regard de la figure 5.

Ce circuit comprend 30 portes ET à deux entrées et 10 portes OU à trois entrées.

Les portes ET sont réunies par groupe de trois, telles que le groupe composé des portes ET 202, 204 et 206.

Les différents groupes de trois portes ET sont associés respectivement à des bits de poids différents des signaux appliqués sur les bus de sortie 186 ou 196 des circuits de calcul 100. L'une des entrées des trois portes de chaque groupe est reliée respectivement à une ligne de bit associé des bus 186A, 186B, 186C, ou 196A, 196B et 196C. L'autre entrée des trois portes de ce groupe reçoit respectivement les signaux de multiplexage A, B et C générés par le module de gestion 500.

Les sorties des portes d'un même groupe sont reliées aux entrées respectives d'une porte OU associée.

La sortie de cette porte OU est reliée à une ligne d'un bus de sortie 201. Ainsi, les nombres N générés par les modules de calcul 100A, 100B et 100C sont multiplexés par le module 200A et disponibles sur le bus 10 bits 201A appliqué au module de division 300.

De façon similaire, les nombres K générés par les modules de calcul 100A, 100B et 100C sont multiplexés par le module 200B et disponibles sur le bus 210B 10 bits appliqué au module de gestion 300.

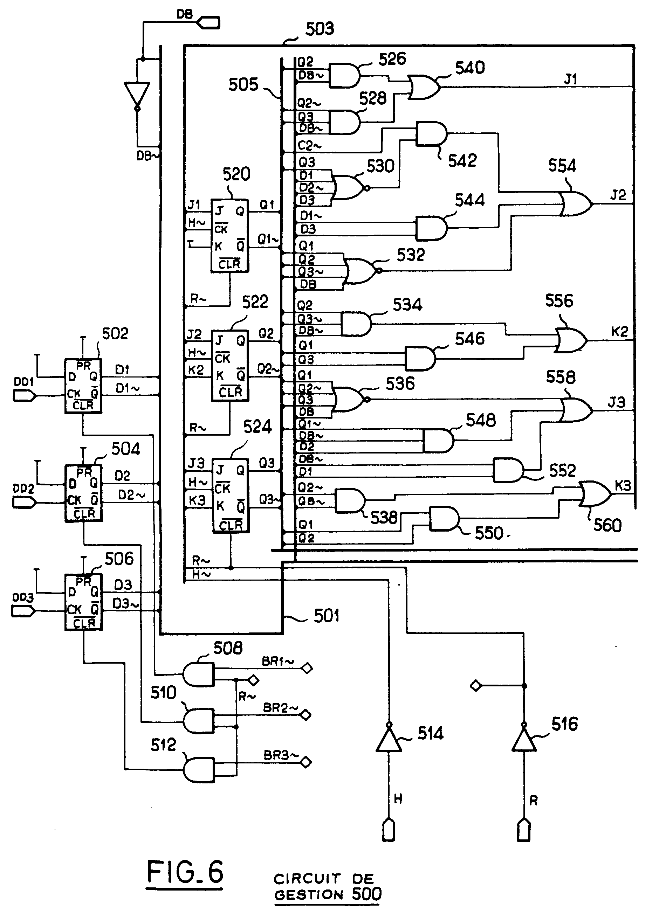

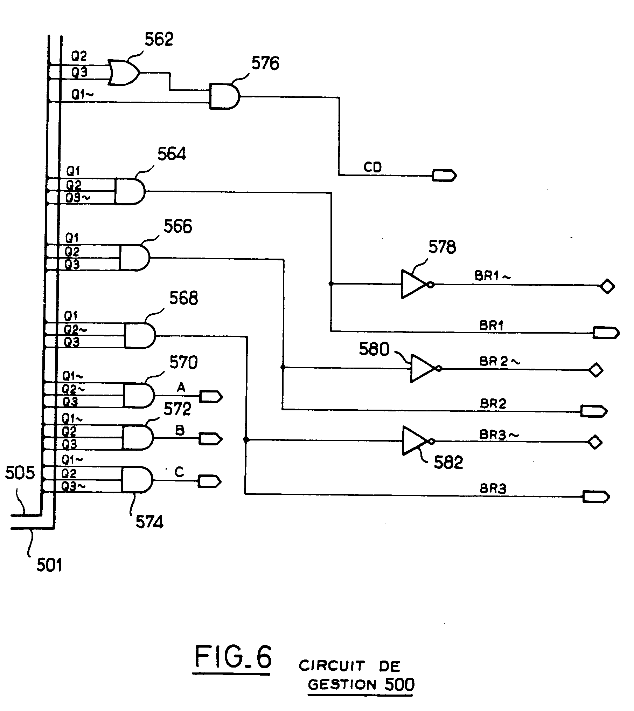

On va maintenant décrire la structure du circuit de gestion 500 illustré sur la figure 6.

Ce circuit reçoit en entrée les signaux DD issus des portes ET 139 des modules de calcul 100A, 100B et 100C (référencés respectivement DD1, DD2, et DD3 sur la figure 6), le signal de cadencement H, le signal de remise à zéro générale R, un signal DB généré par le module diviseur 300 pour indiquer si celui-ci est disponible en vue d'une nouvelle division.

Le circuit de gestion 500 génère en sortie les signaux de multiplexage A, B et C appliqués aux modules de multiplexage 200A, 200B , un signal CD de commande de division appliqué au circuit diviseur 300, et des signaux BR1, BR2 et BR3 appliqués respectivement aux étages tampons de sortie 400A, 400B et 400C.

Le signal de cadencement H et le signal de remise à zéro générale R sont appliqués respectivement aux entrées d'inverseurs 514 et 516.

Les signaux DD1, DD2 et DD3 issus des portes ET 139 intégrées aux modules de calcul 100A, 100B et 100C respectivement sont appliqués sur l'entrée d'horloge CK de bascules D 502, 504 et 506. Ces dernières ont leurs entrées D et PR reliées à une tension d'alimentation positive + Vcc.

Les entrées de remise à zéro $\overline{CLR}$ des bascules 502, 504 et 506 sont reliées respectivement aux sorties de portes ET 508, 510 et 512.

L'une des entrées de ces portes ET 508, 510 et 512 est reliée à la sortie de l'inverseur 516.

L'autre entrée des portes ET 508, 510 et 512 reçoit respectivement un signal $\overline{BR1}$, $\overline{BR2}$ et $\overline{BR3}$ dont la génération sera explicitée par la suite.

Les sorties Q et $\overline{Q}$ de la bascule 502 qui génèrent des signaux référencés respectivement D1 et $\overline{D1}$ sont reliées à des lignes respectives d'un bus auxiliaire 501.

De façon similaire les sorties Q et $\overline{Q}$ de la bascule 504 qui génèrent des signaux référencés D2 et $\overline{D2}$ sur la figure 6 sont reliées à des lignes respectives du bus auxiliaire 501. Enfin, les sorties Q et $\overline{Q}$ de la bascule 506 qui génèrent des signaux référencés D3 et $\overline{D3}$ sont reliées à des lignes respectives du bus auxiliaire 501.

Le signal DB est également appliqué à une des lignes associées du bus auxiliaire 501, de même que la sortie de l'inverseur 518 recevant en entrée le signal DB précité.

Trois bascules JK 520, 522 et 524 sont commandées par un second bus auxiliaire 503. Celui-ci reçoit les signaux $\overline{H}$ et $\overline{R}$ issus des inverseurs 514 et 516 ainsi que des signaux J1, J2, J3, K2 et K3 générés en sortie de portes OU 540, 554, 556, 558 et 560 d'une façon qui sera décrite plus en détail par la suite.

Les entrées de remise à zéro $\overline{CLR}$ des bascules JK 520, 522 et 524 reçoivent le signal $\overline{R}$. Les entrées d'horloge $\overline{CK}$ des bascules 520, 522 et 524 reçoivent le signal de cadencement $\overline{H}$.

L'entrée J de la bascule 520 reçoit le signal J1. L'entrée K de la bascule 520 est reliée à la tension d'alimentation positive + Vcc.

Les entrées J et K de la bascule 522 reçoivent respectivement les signaux J2 et K2.

Les entrées J et K de la bascule 524 reçoivent respectivement les signaux J3 et K3.

Les sorties Q et $\overline{Q}$ des bascules 520, 522 et 524 sont reliées à un troisième bus auxiliaire 505. Les sorties Q et $\overline{Q}$ de la bascule 520 génèrent des signaux Q1 et $\overline{Q1}$ respectivement.

Les sorties Q et $\overline{Q}$ de la bascule 522 génèrent des signaux Q2 et $\overline{Q2}$ respectivement. Enfin, les sorties Q et $\overline{Q}$ de la bascule 524 génèrent des signaux Q3 et $\overline{Q3}$ respectivement.

Les entrées d'une porte ET 526 reçoivent respectivement les signaux Q2 et $\overline{DB}$. Les entrées d'une porte ET 528 à 3 entrées reçoivent respectivement les signaux $\overline{Q2}$, Q3 et $\overline{DB}$. Les sorties des portes ET 526 et 528 sont reliées aux entrées d'une porte OU 540 qui génère en sortie le signal J1 précité appliqué au bus auxiliaire 503.

Les entrées d'une porte NOR 530 à 4 entrées reçoivent respectivement les signaux Q3, D1, $\overline{D2}$ et D3. Les entrées d'une porte ET à deux entrées 542 sont reliées respectivement à la ligne du signal $\overline{Q2}$ et à la sortie de la porte NOR 530.

Les entrées d'une porte ET 544 à deux entrées reçoivent respectivement les signaux $\overline{D1}$ et D3.

Les entrées d'une porte NOR 532 à 4 entrées reçoivent respectivement les signaux Q1, Q2, $\overline{Q3}$ et DB.

Les entrées d'une porte OU 544 à 3 entrées sont reliées respectivement à la sortie des portes ET 542 et 544 et à la sortie de la porte NOR 532. La sortie de la porte OU 554 qui génère le signal J2 précité est reliée au bus auxiliaire 503.

Les entrées d'une porte ET à 3 entrées 534 reçoivent respectivement les signaux Q2, $\overline{Q3}$ et $\overline{DB}$.

Les entrées d'une porte ET à deux entrées 546 reçoivent respectivement les signaux Q1 et Q3.

Les entrées d'une porte OU à deux entrées 556 sont reliées respectivement aux sorties des portes ET 534 et 546.

La sortie de la porte OU 556 qui génère le signal K2 précité est reliée au bus auxiliaire 503.

Les entrées d'une porte NOR à 4 entrées 536 reçoivent respectivement les signaux Q1, $\overline{Q2}$, Q3

et DB.

Les entrées d'une porte ET à trois entrées 548 reçoivent respectivement les signaux $\overline{Q1}$, $\overline{DB}$ et D2.

Les entrées d'une porte ET à deux entrées 552 reçoivent respectivement les signaux $\overline{DB}$ et D1.

Les entrées d'une porte OU 558 à 3 entrées sont reliées respectivement à la sortie de la porte NOR 536 et aux sorties des portes ET 548 et 552.

La sortie de la porte OU 558 qui génère le signal J3 précité est reliée au bus auxiliaire 503.

Les entrées d'une porte ET 538 à deux entrées reçoivent les signaux $\overline{Q2}$ et $\overline{DB}$.

Les entrées d'une porte ET à deux entrées 550 reçoivent les signaux Q1 et Q2.

Les entrées d'une porte OU 560 à deux entrées sont reliées respectivement aux sorties des portes ET 538 et 550.

La sortie de la porte OU 560 qui génère le signal K3 précité est reliée au bus auxiliaire 503.

Une porte OU à deux entrées 562 reçoit les signaux Q2 et Q3.

Les entrées d'une porte ET à deux entrées 576 reçoivent respectivement le signal issu de la porte OU 562 et le signal $\overline{Q1}$.

Le signal CD de commande de division appliqué au diviseur 300 est disponible sur la sortie de la porte ET 576.

Une porte ET 564 à trois entrées reçoit les signaux Q1, Q2 et $\overline{Q3}$.

La sortie de la porte 564 génère le signal BR1 appliqué au tampon de sortie 400A. Par ailleurs, la sortie de la porte ET 564 est reliée à l'entrée d'un inverseur 578. Ce dernier génère en sortie le signal $\overline{BR1}$ appliqué à l'entrée de la porte ET 508 précitée.

Les entrées d'une porte ET 566 à trois entrées reçoivent respectivement les signaux Q1, Q2 et Q3. La porte ET 566 génère en sortie le signal BR2 appliqué au tampon de sortie 400B.

La sortie de la porte ET 566 est également reliée à l'entrée d'un inverseur 580. Ce dernier délivre en sortie le signal $\overline{BR2}$ appliqué à la porte ET 510 précitée.

Les entrées d'une porte ET 568 à trois entrées reçoivent respectivement les signaux Q1, $\overline{Q2}$ et Q3. La sortie de la porte ET 568 délivre le signal BR3 appliqué au tampon de sortie 400C.

La sortie de la porte ET 568 est également reliée à l'entrée d'un inverseur 582 qui génère en sortie le signal $\overline{BR3}$ appliqué à la porte ET 512 précitée.

Les entrées d'une porte ET à trois entrées 570 reçoivent respectivement les signaux $\overline{Q1}$, $\overline{Q2}$ et Q3. La sortie de la porte ET 570 génère en sortie le signal A de multiplexage appliqué aux modules 200A et 200B.

De façon similaire, les entrées d'une porte ET 572 à trois entrées reçoivent respectivement les signaux $\overline{Q1}$, Q2 et Q3. La sortie de la porte ET 572 génère le signal B appliqué aux modules de multiplexage 200A et 200B. Enfin, les entrées d'une porte ET 574 à trois entrées reçoivent respectivement les signaux $\overline{Q1}$, Q2 et $\overline{Q3}$. La sortie de la porte ET 574 génère le signal C de multiplexage appliqué aux modules 200A et 200B.

De préférence, le circuit diviseur 300 est adapté pour calculer le rapport entre les nombres N et K délivrés respectivement par chacun des modules 100A, 100B et 100C, et fournir le résultat en virgule flottante par exemple avec 8 bits de mantisse et 4 bits d'exposant. Le fait d'utiliser un circuit diviseur 300 qui délivre le résultat en virgule flottante permet de limiter largement le nombre de bits de sortie.

Les valeurs de mantisse et d'exposant du résultat délivré par le circuit diviseur 300 sont mémorisées dans les tampons de sortie 400A, 400B et 400C associés respectivement aux signaux appliqués sur les entrées 10, 11 et 12.

De préférence, les tampons de sortie 400A, 400B et 400C sont de structure identique.

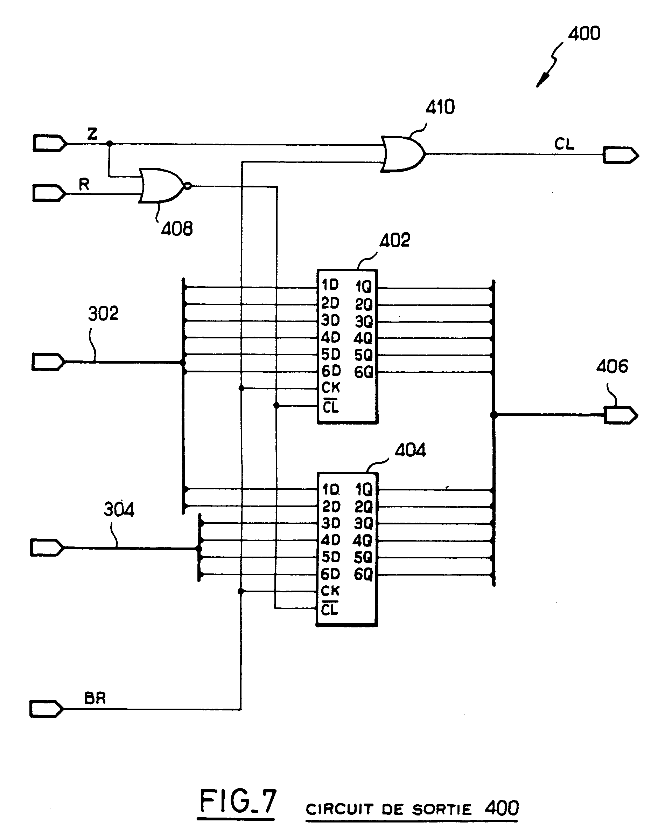

On a illustré schématiquement sur la figure 7 la structure d'un tel tampon de sortie.

Pour l'essentiel, ce tampon de sortie comprend des bascules D montées en parallèle et regroupées par exemple sous forme de deux circuits 402, 404.

A titre d'exemple, dans le cas où le circuit diviseur 300 génère son signal de sortie en virgule flottante avec 8 bits de mantisse et 4 bits d'exposant, 6 bascules D reçoivent par l'intermédiaire d'un bus 302 les bits de mantisse issus du circuit diviseur 300, tandis que 4 bascules D reçoivent d'un bus 304 les bits d'exposant issus du circuit diviseur 300.

Les sorties Q des bascules sont disponibles sur un bus de sortie 12 bits 406.

La mémorisation des données de mantisse et exposant issues du circuit diviseur 300 est validée par les impulsions $BR_i$ générées par le circuit de gestion 500 et appliquées sur les entrées d'horloge CK des bascules 402, 404. La remise à zéro des tampons de sortie 402 et 404 est assurée soit lorsque la fréquence du signal est inférieure à une fréquence prédéterminée, par exemple 2Hz selon le mode de réalisation précédemment décrit, soit lors de la remise à zéro générale.

Pour cela, les signaux Z et R qui correspondent respectivement aux conditions précitées attaquent les entrées d'une porte NOR 408 dont la sortie est reliée aux entrées de remise à zéro $\overline{CL}$ des tampons de sortie 402 et 404.

Par ailleurs, les entrées d'une porte OU 410 reçoivent respectivement les signaux Z et R précités. Ainsi, la sortie de la porte OU 410 génère un signal CL qui indique au circuit aval susceptible d'utiliser le résultat représentatif de la fréquence disponible sur le bus de sortie 406 qu'une nouvelle information séquentielle vient d'être mémorisée dans les tampons de sortie 402 et 404.

Le fait d'utiliser un circuit diviseur 300 qui génère le quotient N/K en virgule flottante avec mantisse et exposant permet de définir aisément la fréquence à mesurer sur la base de ce quotient. En effet, pour obtenir la fréquence à mesurer à l'aide du quotient N/K il suffit d'ajouter aux bits d'exposant un nombre correspondant à la fréquence Fe du signal d'horloge.

A titre d'exemple, dans le cadre du mode de réalisation représenté sur les figures et précédemment décrit, il suffit d'ajouter le nombre 11 à la valeur de l'exposant issu du circuit diviseur 300 pour obtenir directement la fréquence à mesurer.

Selon un mode de réalisation donné à titre d'exemple non limitatif mais ayant donné jusqu'ici satisfaction :

- le compteur 113 est du type 74HC4020,
- les compteurs 154, 160 et 170 sont du type 74HC4040,
- les bascules 158 et 177 sont du type 75HC74,
- le compteur 123 est du type 74HC390,
- les tampons de sortie 182, 184, 192 et 194 sont du type 74HC174,
- les bascules JK 520, 522 et 524 sont du type 74HC73,
- les bascules 502, 504 et 506 sont du type 74HC74,
- les tampons de sortie 402 et 404 sont du type 74HC174.

Il ressort de la description qui précède que les modules de calcul 100A, 100B et 100C déterminent en parallèle les nombres N et K représentatifs de la fréquence des signaux S1, S2 et S3 appliqués respectivement sur les entrées 10, 11 et 12.

Les nombres N et K associés au signal S1, issus du module 100A, sont disponibles sur les bus 186A et 196A.

Les nombres N et K associés au signal S2 issus du module 100B sont disponibles sur les bus de sortie 186B et 196B.

Enfin, les nombres N et K associés au signal S3, issus du module 100C, sont disponibles sur les bus de sortie 186C et 196C.

Les bus 186A, 186B, 186C sont appliqués aux entrées du module de multiplexage 200 A. De façon similaire les bus 196A, 196B et 196C sont reliés aux entrées de l'organe de muliplexage 200B.

Ainsi, le module de multiplexage 200A échantillonne séquentiellement les signaux représentatifs des nombres N issus des modules de calcul 100A, 100B et 100C. Similtanément, le module de multiplexage 200B échantillonne en séquence les signaux représentatifs des nombres K issus des modules de calcul 100A, 100B et 110C.

Les sorties des modules de multiplexage 200A et 200B sont appliqués à l'organe diviseur 300. Celui-ci calcule donc successivement la mantisse et l'exposant du quotient N/K associé respectivement aux signaux S1, S2 et S3.

Les valeurs de la mantisse et de l'exposant des quotients, issues du diviseur 300 sont stockées respectivement dans les tampons de sortie 400A, 400B et 400C.

Le cas échéant, pour tenir compte de la dynamique des signaux d'entrée, on peut définir des temps de mesure Tf différents pour les différentes voies 10, 11 et 12. En d'autres termes, on peut le cas échéant obtenir en augmentant la durée de mesure Tf un lissage des informations sur une durée plus importante.

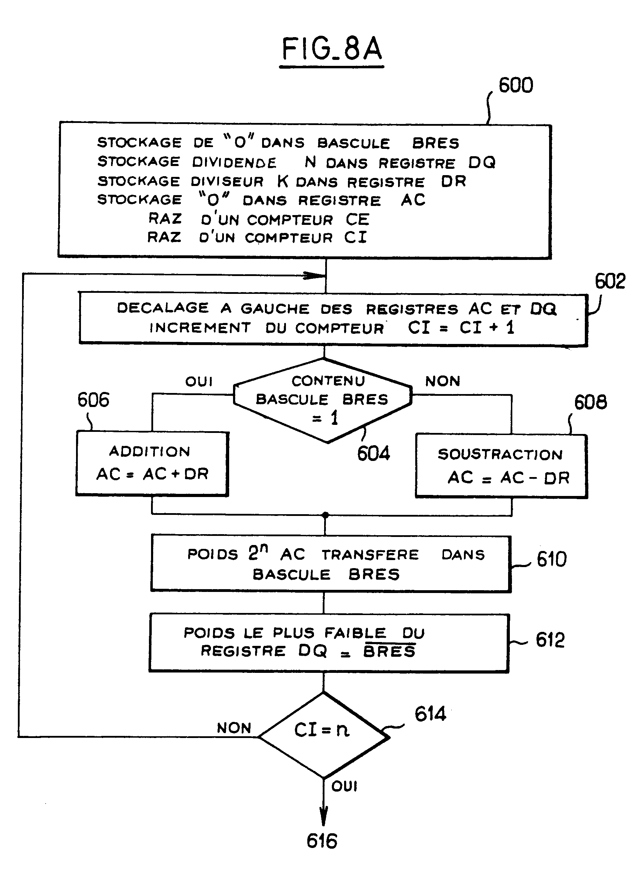

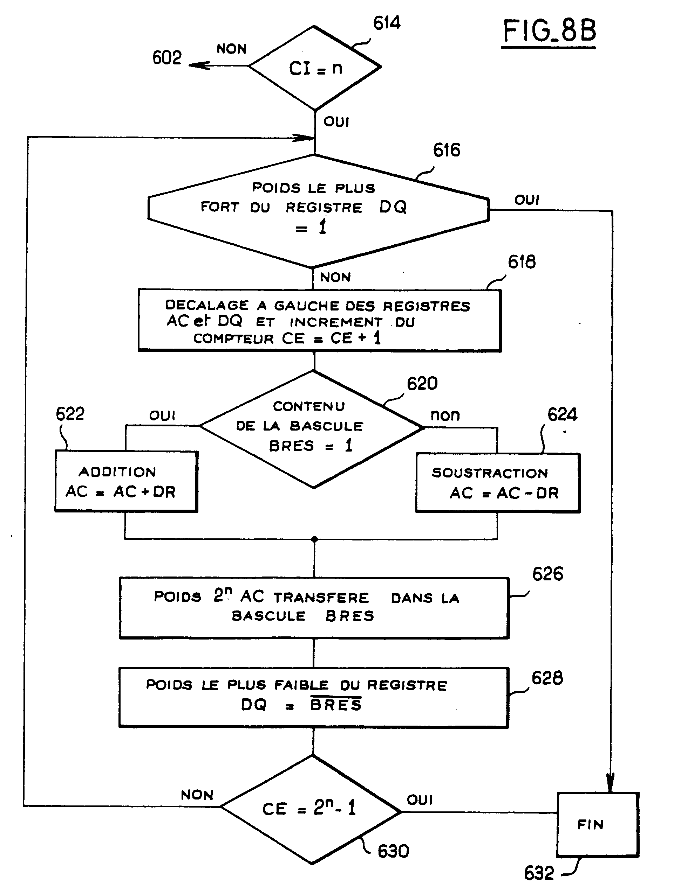

On va maintenant décrire la structure de l'organe diviseur 300 en regard des figures 8 à 10.

On a illustré schématiquement sur la figure 8 un organigramme de fonctionnement du circuit diviseur 300.

Pour l'essentiel, le circuit diviseur opère, pour chaque division partielle, selon l'algorithme suivant :

- retrancher le diviseur du premier chiffre du dividende,
- si le résultat de la soustraction est positif la valeur à retenir pour le premier chiffre du quotient est 1,
- si le résultat de la soustraction est négatif, la valeur à retenir pour le premier chiffre du quotient est 0 et dans ce cas, il faut ajouter le diviseur au résultat trouvé pour restaurer le chiffre initial.

Plus précisément encore, selon la présente invention, pour mettre en oeuvre cet algorithme le circuit diviseur comprend un registre dénommé DQ qui mémorise initialement le dividende, un registre dénommé AC initialisé à zéro et un registre dénommé DR qui reçoit initialement le diviseur.

Ainsi, du départ, le registre AC étant initialisé à zéro, le dividende étant placé dans le registre DQ et le diviseur dans le registre DR, on procède à un premier décalage d'un rang vers la gauche du contenu des registres AC et DQ, puis on soustrait le diviseur du contenu du registre AC. Si la retenue est égale à 1, on définit le poids le plus faible du registre DQ comme étant égal à zéro et la prochaine opération à effectuer correspond à une addition du contenu précédent du registre AC et du contenu du registre DR, le résultat de cette addition étant utilisé pour rafraîchir le registre AC.

Si par contre, la retenue est égale à zéro, on détermine que le poids le plus faible du registre DQ est égal à 1 et la prochaine opération à effectuer correspond à une soustraction consistant à retrancher le contenu du registre DR du contenu précédent du registre AC et à refraîchir le contenu du registre AC avec le résultat de la soustraction.

Avant d'effectuer chaque addition ou chaque soustraction précitée, selon la valeur de la retenue, on effectue un nouveau décalage d'un rang vers la gauche.

Ce processus précité est réitéré en séquence jusqu'à ce que le nombre de décalages effectué soit égal à n si le dividende et le diviseur sont exprimés sur n bits. Le dernier décalage doit être suivi d'une addition ou d'une soustraction. Le résultat de la division se trouve alors dans le registre DQ et le reste dans le registre AC.

Pour délivrer le quotient sous forme d'une mantisse et d'un exposant, le processus précité est relancé dans une seconde phase, en séquence, et arrêté dès que le bit de poids fort du registre DQ se trouve à 1.

La mantisse du quotient est alors dans le registre DQ tandis que l'exposant est disponible en sortie d'un compteur qui a été déchlenché à l'initialisation de la seconde phase et incrémenté à chaque cycle de celle-ci.

On va expliciter plus en détail le procédé de division conforme à la présente invention en regard des figures 8A et 8B annexées.

Comme représenté sur ces figures, la première étape 600 du processus consiste à initialiser à zéro une bascule dénommée BRES qui a pour but de restituer le bit $2^n$ du registre AC, à stocker le dividence N dans le registre DQ, à stocker le diviseur K dans le registre DR , à initialiser le registre AC à zéro, à opérer la remise à zéro d'un compteur CE apte à restituer la valeur de l'exposant et à remettre à zéro un compteur CI qui comptabilise le nombre d'opérations du processus de division.

La second étape 602 du procédé de division consiste à décaler d'un rang vers la gauche le contenu des registres AC et DQ et à incrémenter le compteur d'itération CI d'une unité.

Comme schématisé à l'étape 604 le processus de division consiste alors à détecter si le contenu de la bascule BRES est ou non égal à 1, si oui le bit $2^n$ du registre AC étant égal à 1, on procède à l'étape 606 à l'addition du contenu du registre AC et du contenu du registre DR et au refraîchissement du contenu du registre AC avec le résultat de l'addition.

Par contre, si le résultat de l'interrogation 604 est négatif, c'est-à-dire si le bit $2^n$ du registre AC est à zéro, on procède à l'étape 608 à une soustraction, par retrait du contenu du registre DR du contenu du registre AC et à un refraîchissement du contenu du registre AC par le résultat de la soustraction.

Les étapes 606 et 608 sous suivies par l'étape 610 consistant à transférer dans la bascule BRES le poids $2^n$ du registre AC, puis par l'étape 612 consistant à déterminer le poids le plus faible du registre DQ comme étant égal du complément du contenu de la bascule BRES.

L'étape 612 est suivie par l'étape d'interrogation 614 consistant à vérifier si le nombre d'incrémentations du compteur CI, c'est-à-dire le nombre d'itérations du processus de division est égal au nombre n de bits des nombres N et K. Sinon, le processus précité est réitéré à partir de l'étape 602. Si oui, la première phase du processus de division est terminée, le quotient est disponible au niveau du registre DQ et le reste dans le registre AC.

Néanmoins, l'étape 614 est suivie par la seconde phase du processus de disision visant à délivrer le quotient en virgule flottante sous forme d'une mantisse et d'un exposant.

Pour cela, à l'étape 616 on recherche si le poids le plus fort du registre DQ est égale à 1. Si oui, le processus de division est terminé à l'étape 632. Si non, c'est-à-dire si le poids le plus fort du registre DQ est égal à 0, l'étape 616 est suivie par l'étape 618 consistant à opérer un nouveau décalage vers la gauche d'un rang du contenu des registres AC et DQ et à incrémenter le compteur CE d'exposant d'une unité.

On recherche ensuite à l'étape 620 si le contenu de la bascule BRES est égal à 1.

Si oui, c'est-à-dire si le bit $2^n$ du registre AC est égal à 1, on procède à l'étape 622 à l'addition du contenu des registres AC et DR et au rafraîchissement du contenu de la bascule AC avec le résultat de l'addition.

Si non, c'est-à-dire si le bit $2^n$ du registre AC est égal à zéro, on procède à une soustraction par retrait du contenu du registre DR du contenu du registre AC et au rafraîchissement du contenu du registre AC par le résultat de la soustraction, comme illustré à l'étape 624.

Les étapes 622 et 624 sont suivies de l'étape 626 consistant à transférer dans la bascule BRES le poids $2^n$ du registre AC.

L'étape 626 est suivie de l'étape 628 consistant à rendre le poids le plus faible du registre DQ égal au complément du contenu de la bascule BRES.

L'étape 628 est suivie par l'étape d'interrogation 630 consistant à déterminer si le nombre d'incréments de la seconde phase, c'est-à-dire le contenu du compteur CE est égal à $2^{n-1}$.

Si oui, le processus de division est terminé à l'étape 632.

Par contre, si non, c'est-à-dire si le nombre d'itérations de la seconde phase consécutive à l'étape 614 n'a pas atteint $2^{n-1}$, la seconde phase du processus de division est réitérée à partir de l'étape 616.

Lorsque le processus de division est terminé à l'étape 632, la mantisse du quotient N/K est disponible dans le registre DQ, tandis que l'exposant est disponible en sortie du compteur CE qui a été déclenché à la relance de la seconde phase du processus de division (consécutive à l'étape 614) et incrémenté à chaque cycle, lors du passage par l'étape 618.

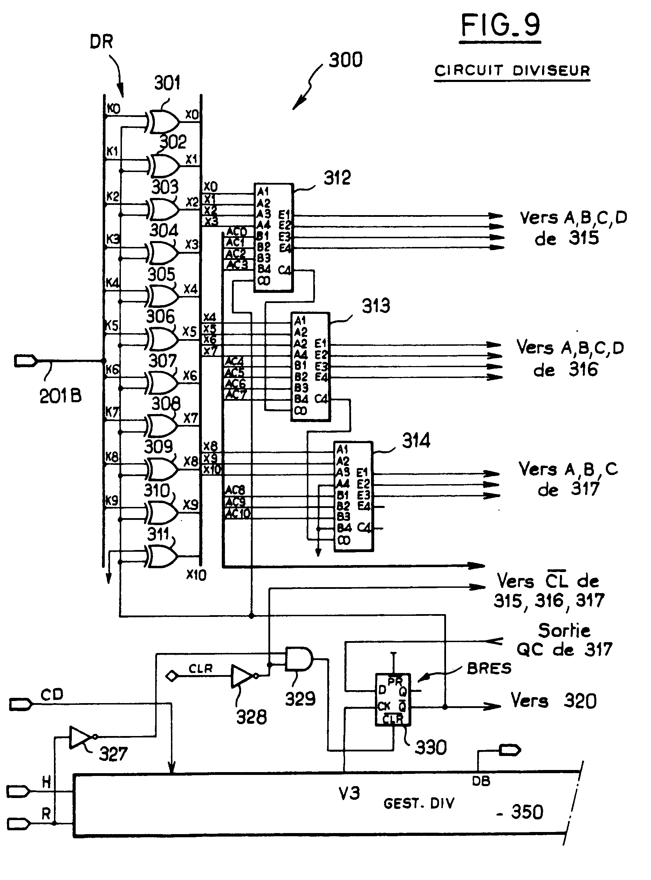

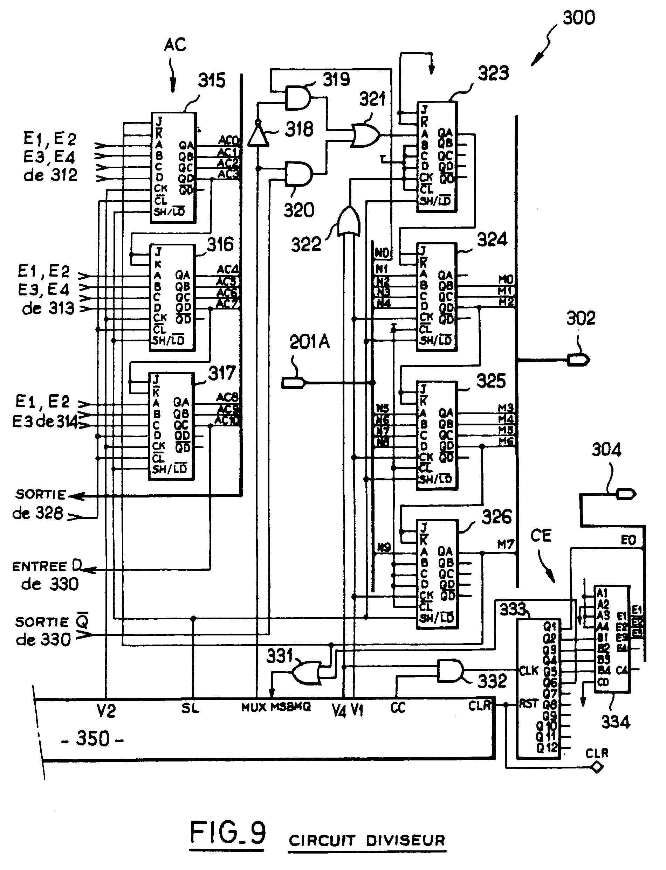

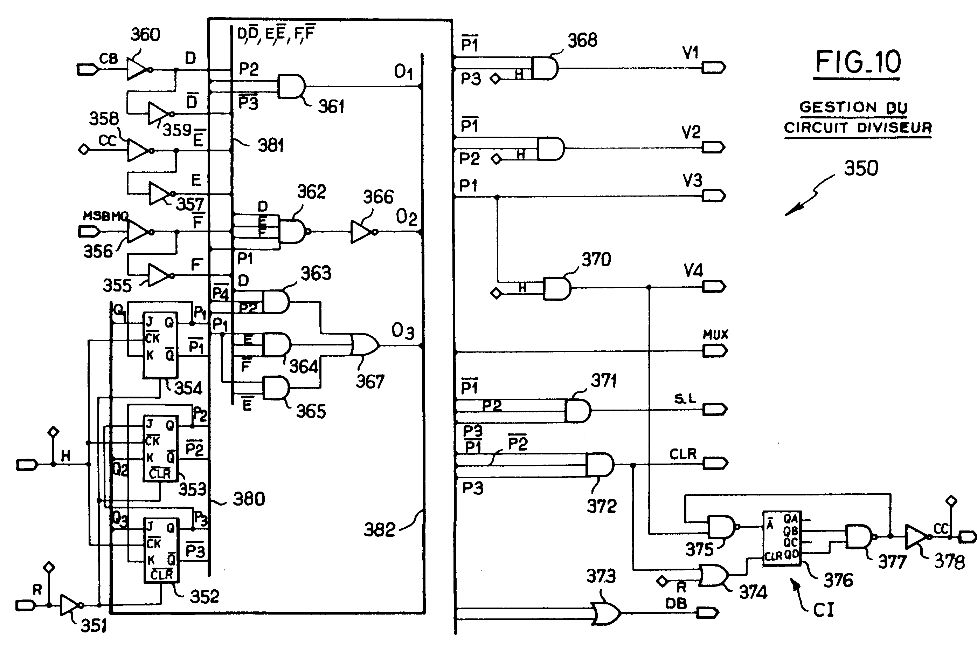

On va maintenant décrire plus en détail la structure du circuit diviseur conforme à la présente invention en regard des figures 9 et 10 annexées.

D'une façon générale, on aperçoit sur la figure 9 une pluralité de portes OU à entrées complémentées 301 à 311, constituant le registre DR, le registre AC composé de trois registres 315, 316 et 317 montés en cascade, un additionneur composé de trois boîtiers 312, 313 et 314 déterminant soit l'addition AC + DR, soit la soustraction AC - DR, la bascule BRES, un registre 323 qui mémorise le complément du contenu de cette bascule, et le registre DQ de dividende composé de trois boîtiers 324, 325, 326 montés en cascade, le compteur CE formé d'un compteur 333 et d'un additionneur 334, et le compteur CI intégré au circuit de gestion de diviseur 350 et constitué d'un compteur 376.

Les additionneurs binaires 312, 313 et 314, formés par exemple de boîtier du type 74HC283 sont reliés par leur entrée A à des sorties respectives des portes OU 301 à 311 précitées.

Ces dernières reçoivent sur l'une de leurs entrées la sortie $\overline{Q}$ de la bascule BRES 330. Les secondes entrées des portes OU 301 à 311 reçoivent respectivement l'un des bits du signal représentant le nombre K issu du circuit de calcul 100, via le multiplexeur 200A.

Les sorties E des additionneurs 312, 313 et 314 sont reliées aux entrées des registres AC 315, 316 et 317. La sortie de ces registres est appliquée sur les entrées B des additionneurs 312, 313 et 314.

Si la sortie $\overline{Q}$ de la bascule BRES 330 est à zéro, la sortie des portes 301 à 311 représente le diviseur DR. Dans ce cas, la sortie $\overline{Q}$ de la bascule BRES 330 étant également reliée à la retenue de poids faible C0 du premier additionneur 312, la sortie des additionneurs 312, 313 et 314 représente le résultat de l'addition AC + DR, c'est-à-dire de l'addition du contenu des registres AC et du signal DR présent en sortie des portes OU 301 à 311.

Par contre, si la sortie $\overline{Q}$ de la bascule BRES 330 est à 1, la sortie des portes OU 301 à 311 représente le complément à 2 du diviseur DR, soit $\overline{DR}$. La retenue $C_0$ de l'additionneur 312 est également à 1. On obtient alors en sortie des additionneurs 312, 313 et 314 un signal représentant le résultat de l'opération AC + $\overline{DR}$ + 1, soit un signal correspondant à la soustraction AC - DR.

Il ressort de l'algorithme de fonctionnement du diviseur que le registre 323 doit être chargé tantôt par le bit de poids faible du dividende, tantôt par la sortie de la bascule BRES 330. Pour cela, on utilise un multiplexeur 2 voies, composé de deux portes ET 319, 320, un inverseur 318 et une porte OU 321.

La sortie de la porte OU 321 attaque l'entrée du registre 323.

Les entrées de la porte OU 321 sont reliées respectivement en sortie des portes ET 319 et 320.

Une première entrée de la porte ET 319 reçoit un signal de multiplexage MUX généré par le circuit de gestion 350, par l'intermédiaire d'un inverseur 318. La seconde entrée de la porte ET 319 reçoit le bit de poids faible du dividende, soit $N_0$ sur la figure 9.

La première entrée de la port ET 320 est reliée à la sortie $\overline{Q}$ de la bascule BRES. La seconde entrée de la porte ET 320 reçoit le signal de multiplexage MUX précité.

Les registres 324, 325 et 326 reçoivent en entrée les bits de signal représentant le dividende N et génèrent en sortie, par exemple sur un bus 302 huit bits le signal de mantisse N.

Par ailleurs, le signal de remise à zéro générale R est appliqué à l'entrée d'un inverseur 327. Ce dernier attaque la première entrée d'une porte ET 329. La seconde entrée de la porte ET 329 est reliée à la sortie d'un inverseur 328 qui reçoit lui-même en entrée un signal CLR généré par le circuit de gestion 350 d'une façon qui sera décrite plus en détail par la suite.

La sortie de l'inverseur 328 est en outre reliée aux entrées de remise de zéro des registres 315, 316 et 317.

La sortie de la porte ET 329 attaque l'entrée de remise à zéro $\overline{CLR}$ de la bascule BRES 330.

Le compteur CE qui détermine la valeur de l'exposant comprend en cascade un compteur 333 cinq bits et un additionneur 334 quatre bits.

L'entrée de remise à zéro RST du compteur 333 reçoit le signal CLR précité.

L'entrée d'horloge CLK du compteur 333 est reliée à la sortie d'une porte ET 332.

Les entrées de celle-ci reçoivent respectivement des signaux V4 et CC générés par le circuit de gestion 350 d'une façon qui sera décrite plus en détail par la suite.

Les entrées Q1 à Q5 du compteur 333 attaquent les entrées A2, B1, B2, B3 et B4 de l'additionneur 4 bits 334. Les entrées A1, A3 et A4 de ce dernier sont reliées à une tension d'alimentation positive + Vcc. L'entre de retenue $C_0$ de l'additionneur 334 est reliée à la masse.

La sortie Q1 du compteur 333 détermine le poids le plus faible de l'exposant, les trois bits de poids supérieur étant déterminés par les sorties E1, E2 et E3 de l'additionneur 334.

Les 4 bits d'exposant ainsi formés sont disponibles sur le bus 304 de sortie 4 bits qui correspond à la sortie Q1 du compteur 333 et aux sorties E1, E2 et E3 de l'additionneur 334.

La sortie Q6 du compteur 333 est également reliée à une première entrée d'une porte OU 331. La seconde entrée de cette dernière est reliée à la sortie QA du dernier boîtier 326 du registre DQ de dividende.

La sortie de la porte OU 331 qui génère un signal référencé MSBMQ est appliqué au circuit de gestion de diviseur 350.

On va maintenant décrire la structure de ce dernier en regard de la figure 10.

Le circuit de gestion 350 reçoit en entrée le signal de cadencement H, le signal de remise à zéro générale R, le signal MSBMQ disponible en sortie de la porte OU 331, et le signal CD délivré par le circuit de gesion 500 en sortie de la porte ET 576.

Le signal de remise à zéro générale R est appliqué à l'entrée d'un inverseur 351.

La sortie de ce dernier attaque les entrées de remise à zéro $\overline{CLR}$ de trois bascules JK 352, 353 et 354.

Ces dernières reçoivent sur leur entrée d'horloge CK le signal de cadencement H.

L'entrée J de la bascule 352 reçoit un signal 03 généré d'une façon qui sera décrite plus en détail par la suite.

L'entrée K de la bascule 352 est reliée à la sortie Q de la bascule 353.

Les sorties Q et $\overline{Q}$ de la bascule 352 génèrent des signaux P3 et $\overline{P3}$ appliqués à un bus auxiliaire 380.

L'entrée J de la bascule 353 est reliée à la sortie Q de la bascule 352. L'entrée K de la bascule 353 reçoit un signal 02 généré d'une façon qui sera décrite plus en détail par la suite.

Les sorties Q et $\overline{Q}$ de la bascule 353 génèrent des signaux P2 et $\overline{P2}$ appliqués sur le bus auxiliaire 380.

L'entrée J de la bascule 354 reçoit un signal 01 généré d'une façon qui sera décrite plus en détail par la suite.

L'entrée K de la bascule 354 est reliée à la sortie Q de cette bascule.

Les sorties Q et $\overline{Q}$ de la bascule 354 génèrent des signaux P1 et $\overline{P1}$ appliqués au bus auxiliaire 380.

Le signal MSBMQ issu de la porte OU 331 est appliqué à un inverseur 356. Ce dernier génère en sortie un signal $\overline{F}$ appliqué à un autre bus auxiliaire 381.

La sortie de l'inverseur 356 est également reliée à l'entrée d'un inverseur 355 qui génère en sortie un signal F appliqué au bus auxiliaire 381.

Un signal CC généré d'une façon qui décrite plus en détail par la suite est appliqué à l'entrée d'un inverseur 358. Ce dernier génère en sortie un signal $\overline{E}$ appliqué au bus auxiliaire 381. La sortie de l'inverseur 358 qui génère en sortie un signal E appliqué de même au bus auxiliaire 381.

Enfin, le signal CD généré par le circuit de gestion 500, en sortie de la porte ET 576, est appliqué à l'entrée d'un inverseur 360. Ce dernier génère en sortie un signal $\overline{D}$ appliqué au bus auxiliaire 381. La sortie de l'inverseur 360 est également relié à l'entrée d'un inverseur 359 qui génère en sortie un signal D appliqué de même au bus auxiliaire 381.

Une porte ET à deux entrées 361 reçoit en entrée les signaux P2 et $\overline{P3}$ et génère en sortie le signal 01 précité appliqué à un bus auxiliaire 382.

Une porte NAND 362 à 4 entrées reçoit respectivement les signaux D, E, F et P1. La sortie de la porte NAND 362 est reliée à l'entrée d'un inverseur 366 dont la sortie génère le signal 02 précité appliqué au bus auxiliaire 382.

Une porte ET à trois entrées 362 reçoit les signaux D, $\overline{P1}$ et $\overline{P2}$.

Une porte ET 364 à trois entrées reçoit les signaux P1, E et $\overline{F}$.

Une porte ET à deux entrées 365 reçoit les signaux P1 et $\overline{E}$.

Les entrées d'une porte OU 367 à trois entrées sont reliées respectivement aux sorties des portes 363, 364 et 365. La sortie de la porte OU 367 génère le signal 03 précité appliqué au bus auxiliaire 381.

Une porte ET à trois entrées 368 reçoit respectivement les signaux $\overline{P1}$, P3 et le signal de cadencement H. La sortie de la porte ET 368 génère un signal V1 appliqué aux entrées d'horloge CK des registres 324, 325 et 326, ainsi qu'à la première entrée d'une porte OU 322 dont la sortie est reliée à l'entrée d'horloge CK du registre 323.

Les entrées d'une porte ET à trois entrées 369 reçoivent respectivement les signaux $\overline{P1}$, P2 et le signal de cadencement H. La sortie de la porte ET369 génère un signal V2 appliqué sur les entrées d'horloge CK des registres AC 315, 316 et 317.

Le signal V3 appliqué V3 appliqué sur l'entrée d'horloge CK de la bascule BRES 330 correspond au signal P1 disponible sur le bus auxiliaire 380.

Une porte ET à deux entrées 370 reçoit en entrée les signaux P1 et le signal de cadencement H.

La sortie de la porte ET 370 délivre un signal V4 appliqué sur la seconde entrée de la porte OU 322.

Une porte ET à trois entrées 371 reçoit les signaux $\overline{P1}$, P2 et P3.

La porte ET 371 génère en sortie un signal SL appliqué sur les entrées SH/$\overline{LD}$ des registres 315,

316, 317, 323, 324, 325 et 326.

Une porte ET 372 à trois entrées reçoit les signaux $\overline{P1}$, $\overline{P2}$ et P3. La sortie de la porte ET 372 génère le signal CLR précité.

La sortie de la porte E 372 est également appliqué à une première entrée d'une porte OU 374 à deux entrées dont la seconde entrée reçoit le signal de remise à zéro générale R.

La sortie de la porte OU 374 est reliée à l'entrée de remise à zéro CLR d'un compteur 376 formant le compteur CI.

L'entrée $\overline{A}$ de ce compteur est reliée à la sortie d'une porte NAND 375.

Les entrées de cette dernière sont reliées respectivement à la sortie de la porte ET 370 précitée et à la sortie d'une porte NAND 377.

Les sorties QB et QD du compteur 376 sont reliées respectivement aux entrées de la porte NAND 377.

La sortie de cette dernière est reliée, en plus de l'une des entrées de la porte NAND 375 à l'entrée d'un inverseur 378.

Ce dernier délivre en sortie le signal CC appliqué à l'une des entrées de la porte ET 332.

Une porte OU à deux entrées 373 reçoit les signaux P2 et P3.

La sortie de la porte OU 373 génère le signal DB.

Ce signal est à 1 lorsqu'une division est en cours. Il est par contre à zéro quand le diviseur a terminé son calcul ou lorsqu'il est en attente d'une demande de division.

Le signal DB peut être utilisé par un circuit aval utilisant la fréquence du signal sous forme de la mantisse M et de l'exposant E.

En conclusion, lorsque le circuit diviseur 300 a terminé son processus de fonctionnement, la mantisse du quotient est disponible sur 8 bits au niveau du bus 302 relié aux registres 324, 325 et 326. De même l'exposant du quotient N/K est disponible sous 4 bits sur le bus de sortie 304 relié au compteur 333 et à l'additionneur 334.

De préférence, le circuit illustré schématiquement sur la figure 3 est réalisé sous forme d'un circuit intégré.

**Revendications**

1. Procédé de mesure de la fréquence d'un signal électrique (S), du type comprenant les étapes qui consistent à :

    i) définir un temps de mesure (Tf) durée fixe prédéterminée,

    ii) détecter les fronts d'un sens donné, montant ou descendant, du signal (S) à mesurer, et générer des signaux de commande de porte synchronisés d'une part sur le premier front de sens donné du signal (S) pendant le temps de mesure (Tf), et synchronisés d'autre part sur le premier front de sens donné du signal (S) consécutif à l'échéance du temps de mesure (Tf),

    iii) compter dans un premier compteur le nombre (N) de fronts de sens donné du signal (S) entre le premier front du sens donné du signal (S) pendant le temps de mesure (Tf) et le premier front de sens donné du signal (S) consécutif à l'échéance du temps de mesure (Tf),

    iv) fournir un signal d'horloge (He) de fréquence constante,

    v) compter dans un second compteur le nombre (K) d'impulsions d'horloge générées entre le premier front de sens donné du signal (S) pendant le temps de mesure (Tf) et le premier front de sens donné du signal (S) consécutif à l'échéance du temps de mesure (Tf), et,

    vi) déterminer le rapport entre d'une part, le nombre (N) de fronts du signal (S) comptés par le premier compteur et d'autre part, le nombre (K) d'impulsions d'horloge comptées par le second compteur,

caractérisé par le fait que la détection des fronts du signal (S) est exploitée pour synchroniser l'origine du temps de mesure (Tf) sur un premier front de sens donné du signal (S).

2. Procédé de mesure selon la revendication 1, caractérisé par le fait que la période du signal d'horloge (He) est environ 100 fois plus faible que la durée du temps de mesure (Tf).

3. Procédé de mesure selon l'une des revendications 1 ou 2, caractérisé par le fait que la durée du temps de mesure (Tf) est comprise entre 40 et 200 ms en étant de préférence de l'ordre de 50ms.

4. Procédé de mesure selon l'une des revendications 1 à 3, caractérisé par le fait que la fréquence du signal (S) est obtenue en multipliant par la fréquence du signal d'horloge (He), le résultat du rapport entre, d'une part, le nombre (N) de fronts du signal calculé à l'étape iii) et d'autre part, le nombre (K) d'impulsions d'horloge calculé à l'étape v).

5. Dispositif de mesure de la fréquence d'un signal électrique (S) pour la mise en oeuvre du procédé conforme à l'une des revendications 1 à 4, du type comprenant :

    - un ensemble (110) qui définit un temps de mesure (Tf) de durée fixe prédéterminée,

- des moyens de détection (130) qui détectent les fronts d'un sens donné, montant ou descendant, du signal (S) pour générer des signaux de commande de porte synchronisés d'une part sur le premier front de sens donné du signal pendant le temps de mesure (Tf) et synchronisés d'autre part sur le premier front de sens donné du signal (S) consécutif à l'échéance du temps de mesure (Tf),
- un premier compteur (160) piloté par les signaux de commande de porte et qui compte le nombre (N) de fronts de sens donné du signal (S) entre le premier front de sens donné du signal (S) pendant le temps de mesure (Tf) et le premier front de sens donné du signal (S) consécutif à l'échéance du temps de mesure (Tf),
- une horloge (150) qui délivre un signal d'horloge (He) de fréquence constante,
- un second compteur (170) piloté par les signaux de commande de porte et qui compte le nombre (K) d'impulsions d'horloge générés entre le premier front de sens donné du signal (S) pendant le temps de mesure (Tf) et le premier front de sens donné du signal (S) consécutif à l'échéance du temps de mesure (Tf), et
- une cellule (300) apte à déterminer le rapport entre, d'une part, le nombre (N) de fronts du signal (S) comptés par le premier compteur (160) et d'autre part, le nombre d'impulsions (K) d'horloge comptées par le second compteur (170),
caractérisé par le fait que les moyens (130) de détection qui détectent les fronts du signal (S) sont reliés à l'ensemble (110) qui définit le temps de mesure (Tf) de durée fixe prédéterminée et agissent sur cet ensemble (110) pour synchroniser l'origine du temps de mesure (Tf) sur un premier front de sens donné du signal (S).

6.  Dispositif de mesure selon la revendication 5, caractérisé par le fait que la période du signal d'horloge (He) est environ 100 fois plus faible que la durée du temps de mesure (Tf).

7.  Dispositif de mesure selon l'une des revendications 5 et 6, caractérisé par le fait que la durée du temps de mesure (Tf) est comprise entre 40 et 200 ms en étant de préférence de l'ordre de 50ms.

8.  Dispositif de mesure selon l'une des revendications 5 à 7, caractérisé par le fait que la période du signal d'horloge (He) est de l'ordre

de 500$\mu$s.

9.  Dispositif de mesure selon l'une des revendications 5 à 8 permettant de mesurer la fréquence de plusieurs signaux électriques, caractérisé par le fait qu'il comprend :
    - plusieurs modules de traitement (100A, 100B, 100C) comportant chacun :
    - un ensemble (110) qui définit un temps de mesure de durée fixe prédéterminée,
    - des moyens de détection (130) qui détectent les fronts d'un sens donné, montant ou descendant, d'un signal respectivement associé, pour générer des signaux de commande de porte synchronisés d'une part sur le premier front de sens donné du signal pendant le temps de mesure et synchronisés d'autre part sur le premier front de sens donné du signal consécutif à l'échéance du temps de mesure,
    - un premier compteur (160) piloté par les signaux de commande de porte et qui compte le nombre (N) de fronts de sens donné du signal entre le premier front de sens donné du signal pendant le temps de mesure et le premier front de sens donné du signal consécutif à l'échéance du temps de mesure,
    - une horloge (150) qui délivre un signal d'horloge (He) de fréqence constante,
    - un second compteur (170) piloté par les signaux de commande de porte et qui compte le nombre (K) d'impulsions d'horloge générées entre le premier front de sens donné du signal pendant le temps de mesure et le premier front de sens donné du signal consécutif à l'échéance du temps de mesure,
    - deux modules de multiplexage (200A, 200B) comportant chacun un nombre d'entrées égal au nombre de modules de traitement (100A, 100B, 100C) et une sortie unique, qui reçoivent en entrée, l'un, des signaux (VN$_1$, VN$_2$, VN$_3$) représentatifs du contenu de chacun des premiers compteurs, l'autre, des signaux (VK$_1$, VK$_2$, VK$_3$) représentatifs du contenu de chacun des seconds compteurs, pour multiplexer ces signaux,
    - une cellule de calcul unique (300) qui détermine séquentiellement et successivement le rapport entre le nombre (N) compté par le premier compteur (160), et le nombre (K) compté par le second compteur (170) de chaque module de traitement (100A, 100B, 100C) , et
    - des cellules de mémorisation (440A, 400B, 400C) en nombre égal au nombre de modules de traitement (100A, 100B, 100C), adaptées pour mémoriser respectivement le résultat déterminé par la cellule de calcul, correspondant à un signal associé.

10. Dispositif de mesure selon l'une des revendications 5 à 9, caractérisé par le fait que chaque ensemble (110) comprend un compteur (113) qui reçoit sur son entrée d'horloge un signal de cadencement de base (H) et dont les sorties sont reliées à des portes logiques (114-121) qui délivrent en sortie un signal (Tf) représentatif du temps de mesure de durée déterminée.

11. Dispositif de mesure selon l'une des revendications 5 à 10, caractérisé par le fait que la détection du premier front de sens donné du signal (S) consécutif à l'échéance du temps de mesure (Tf) est opéré par un ensemble de portes logiques (133, 134,135, 137) et de bascules (136, 138).

12. Dispositif de mesure selon l'une des revendications 5 à 11, caractérisé par le fait que chaque horloge (150) comprend un compteur (154) qui reçoit sur son entrée d'horloge un signal de cadencement de base (H) et dont les sorties sont reliées à des portes logiques (155, 156, 157) qui délivrent en sortie le signal d'horloge (He).

13. Dispositif de mesure selon l'une des revendications 5 à 12, caractérisé par le fait que le premier compteur (160) reçoit le signal dont on veut mesurer la fréquence sur son entrée d'horloge (CLK) et reçoit sur son entrée de remise à zéro (RST) un créneau de commande dont la période correspond à l'intervalle de temps séparant l'origine du temps de mesure (Tf) du premier front de sens donné du signal (S) consécutif à l'échéance du temps de mesure.

14. Dispositif de mesure selon l'une des revendications 5 à 13, caractérisé par le fait que le second compteur (170) reçoit le signal d'horloge (He) sur son entrée d'horloge (CLK) et reçoit sur son entrée de remise à zéro (RST) un créneau de commande dont la période correspond à l'intervalle de temps séparant l'origine du temps de mesure (Tf) du premier front de sens donné du signal (S) consécutif à l'échéance de le temps de mesure.

15. Dispositif de mesure selon l'une des revendications 5 à 14, caractérisé par le fait que l'une des sorties de poids fort du second compteur (170) génère un signal (Z) indiquant que la fréquence du signal d'entrée est inférieure à un seuil de mesure prédéterminé.

16. Dispositif de mesure selon l'une des revendications 5 à 15, caractérisé par le fait que des tampons de mémorisation (182, 184, 192, 194) sont connectés en sortie des premiers et seconds compteurs (160, 170).

17. Dispositif de mesure selon l'une des revendications 5 à 16 prise en combinaison avec la revendication 9, caractérisé par le fait que chaque module de multiplexage (200A, 200B) est formé d'un ensemble de portes logiques (202-298).

18. Dispositif de mesure selon l'une des revendications 5 à 17 prise en combinaison avec la revendication 9, caractérisé par le fait que les cellules de mémorisation (400A, 400B, 400C) adaptées pour mémoriser le résultat déterminé par la cellule de calcul sont formées de bascules (402, 404).

19. Dispositif de mesure selon l'une des revendications 5 à 18, caractérisé par le fait que chaque cellule de calcul (300) fournit le résultat du rapport entre d'une part, le nombre (N) de fronts du signal comptés pendant la fenêtre de mesure (Tf) par le premier compteur (160) et d'autre part, le nombre d'impulsions (K) d'horloge comptés par le second compteur (170), en virgule flottante sous forme d'une mantisse et d'un exposant.

20. Dispositif de mesure selon la revendication 19, caractérisé par le fait qu'il comprend au moins une cellule de mémorisation (400) comprenant un premier sous-ensemble (402) adapté pour mémoriser la mantisse et un second sous-ensemble (404) adapté pour mémoriser l'exposant.

21. Dispositif de mesure selon l'une des revendications 5 à 20, caractérisé par le fait que chaque cellule de calcul (300) comprend :
    - un registre principal (DQ, 324, 325, 326) qui mémorise initialement le dividende correspondant au nombre (N) de fronts comptés par le premier compteur (160) pendant le temps de mesure,
    - un registre auxiliaire (AC, 315, 316, 317) initialisé à zéro, et
    - un registre secondaire (DR, 301-311) qui reçoit initialement le diviseur correspondant au nombre (K) d'impulsions comptées sur le second compteur (170), la cellule de calcul (300) étant commandée pour réaliser les étapes suivantes :

a) décalage d'un rang vers la gauche du contenu du registre principal (DQ) et du registre auxiliaire (AC),

b) soustraction du contenu du registre secondaire (DR) du contenu du registre auxiliaire (AC),

c) si la retenue de l'étape b) est égale à 1, définition du poids le plus faible du registre principal (DQ) comme étant égal à zéro et addition du contenu du registre auxiliaire (AC) et du contenu du registre secondaire (DR), le résultat de l'addition étant utilisé pour rafraîchir le registre auxiliaire (AC),

d) si la retenue de l'étape b) est égale à zéro, définition du poids le plus faible du registre principal (DQ), comme étant égal à 1 et soustraction du contenu du registre secondaire (DR) du contenu du registre auxiliaire (AC), le résultat de la soustraction étant utilisé pour rafraîchir le contenu du registre auxiliaire (AC),

e) avant chaque addition ou soustraction aux étapes c) et d) décalage d'un rang vers la gauche du contenu du registre principal (DQ) et du registre auxiliaire (AC),

f) réitération des étapes b) à e) un nombre de fois égal à n-1, n correspondant au nombre de bits du dividende (N) et du diviseur (K).

22. Dispositif de mesure selon la revendication 21, caractérisé par le fait que au cours d'une seconde phase les étapes a) à e) sont réitérées jusqu'à ce que le bit de poids fort du registre principal (DQ) soit égal à 1 et qu'il comprend de plus un compteur auxiliaire (CE) incrémenté a chaque itération de la seconde phase, auquel cas la mantisse du résultat recherché est disponible dans le registre principal (DQ) tandis que l'exposant est disponible en sortie du compteur auxiliaire (CE).

**Claims**

1. Process for measuring the frequency of an electrical signal (S), of the type comprising steps which consist in:

i) defining a measurement period (Tf) of predetermined fixed duration,

ii) detecting the fronts in a given direction, ascending or descending, of the signal (S) to be measured, and generating gate control signals synchronized on the one hand with the first front in the given direction of the signal (S) during the measurement period (Tf), and synchronized on the other hand with the first front in the given direction of the signal (S) following expiry of the measurement period (Tf),

iii) counting in a first counter the number (N) of fronts in the given direction of the signal (S) between the first front of the given direction of the signal (S) during the measurement period (Tf) and the first front in the given direction of the signal (S) following the expiry of the measurement period (Tf),

iv) supplying a clock signal (He) of constant frequency,

v) counting in a second counter the number (K) of clock pulses generated between the first front in the given direction of the signal (S) during the measurement period (Tf) and the first front in the given direction of the signal (S) following expiry of the measurement period (Tf), and

vi) determining the ratio between on the one hand the number (N) of fronts of the signal (S) which are counted by the first counter and on the other hand a number (K) of clock pulses counted by the second counter,

characterized in that detection of the fronts of the signal (S) is used to synchronize the origin of the measurement period (Tf) with a first front in the given direction of the signal (S).

2. Measurement process according to Claim 1, characterized in that the cycle of the clock signal (He) is approximately 100 times smaller than the duration of the measurement period (Tf).

3. Measurement process according to one of Claims 1 or 2, characterized in that the duration of the measurement period (Tf) is between 40 and 200 ms, preferably in the order of 50 ms.

4. Measurement process according to one of Claims 1 to 3, characterized in that the frequency of the signal (S) is obtained by multiplying by the frequency of the clock signal (He), the result of the ratio between, on the one hand, the number (N) of the fronts of the signal calculated in step iii) and, on the other hand, the number (K) of clock pulses calculated in step v).

5. Device for measuring the frequency of an electrical signal (S) for implementing the process according to one of Claims 1 to 4, of the type comprising:

- a unit (110) which defines a measurement period (Tf) of predetermined fixed duration,
- detection means (130) which detect the fronts in a given direction, ascending or descending, of the signal (S) to generate gate control signals synchronized on the one hand with the first front in the given direction of the signal during the measurement period (Tf) and synchronized on the other hand with the first front in the given direction of the signal (S) following expiry of the measurement period (Tf),
- a first counter (160) operated by the gate control signals and counting the number (N) of fronts in the given direction of the signal (S) between the first front in the given direction of the signal (S) during the measurement period (Tf) and the first front in the given direction of the signal (S) following expiry of the measurement period (Tf),
- a clock (150) which supplies a clock signal (He) of constant frequency,
- a second counter (170) operated by the gate control signals and counting the number (K) of clock pulses generated between the first front in the given direction of the signal (S) during the measurement period (Tf) and the first front in the given direction of the signal (S) following expiry of the measurement period (Tf), and
- a cell (300) suitable for determining the ratio between on the one hand the number (N) of fronts of the signal (S) which are counted by the first counter (160) and on the other hand the number of clock pulses (K) counted by the second counter (170), characterized in that the detection means (130) which detect the fronts of the signal (S) are connected to the unit (110) which defines the measurement period (Tf) of predetermined fixed duration and act on this unit (110) to synchronize the origin of the measurement period (Tf) with a first front in the given direction of the signal (S).

6. Measurement device according to claim 5, characterized in that the cycle of the clock signal (He) is approximately 100 times smaller than the duration of the measurement period (Tf).

7. Measurement device according to one of Claims 5 and 6, characterized in that the duration of the measurement period (Tf) is between 40 and 200 ms, preferably in the order of 50 ms.

8. Measurement device according to one of Claims 5 to 7, characterized in that the cycle of the clock signal (He) is in the order of 500 $\mu$s.

9. Measurement device according to one of Claims 5 to 8, allowing the frequency of a plurality of electrical signals to be measured, characterized in that it comprises:

- a plurality of processing modules (100A, 100B, 100C) each having:
- a unit (110) which defines a measurement period of predetermined fixed duration,
- detection means (130) which detect the fronts in a given direction, ascending or descending, of a respectively associated signal, to generate gate control signals synchronized on the one hand with the first front in the given direction of the signal during the measurement period and synchronized on the other hand with the first front in the given direction of the signal following expiry of the measurement period,
- a first counter (160) operated by the gate control signals and counting the number (N) of fronts in the given direction of the signal between the first front in the given direction of the signal during the measurement period and the first front in the given direction of the signal following expiry of the measurement period,
- a clock (150) which supplies a clock signal (He) of constant frequency,
- a second counter (170) operated by the gate control signals and counting the number (K) of clock pulses generated between the first front in the given direction of the signal during the measurement period and the first front in the given direction of the signal following expiry of the measurement period,
- two multiplexing modules (200A, 200B) each having a number of inputs equal to the number of processing modules (100A, 100B, 100C) and a single output, and one receiving as input signals (VN$_1$, VN$_2$, VN$_3$) representing the contents of each of the first counters, and the other receiving signals (VK$_1$, VK$_2$, VK$_3$) representing the contents of each of the second counters, to multiplex the signals,

- a single calculation cell (300) which determines sequentially and successively the ratio between the number (N) counted by the first counter (160) and the number (K) counted by the second counter (170) of each processing module (100A, 100B, 100C), and

- storage cells (440A, 400B, 400C) equal in number to the number of processing modules (100A, 100B, 100C) and adapted to store respectively the result determined by the calculation cell, corresponding to an associated signal.

10. Measurement device according to one of Claims 5 to 9, characterized in that each unit (110) comprises a counter (113) which receives at its clock input a basic timing signal (H) and whereof the outputs are connected to logic gates (114-121) which supply as output a signal (Tf) representing the measurement period of predetermined duration.

11. Measurement device according to one of Claims 5 to 10, characterized in that detection of the first front in the given direction of the signal (S) following expiry of the measurement period (Tf) is carried out by an assembly of logic gates (133, 134, 135, 137) and of flipflops (136, 138).

12. Measurement device according to one of claims 5 to 11, characterized in that each clock (150) comprises a counter (154) which receives at its clock input a basic timing signal (H) and whereof the outputs are connected to logic gates (155, 156, 157) which supply as output the clock signal (He).

13. Measurement device according to one of Claims 5 to 12, characterized in that the first counter (160) receives the signal whereof the frequency is to be measured at its clock input (CLK) and receives at its reset input (RST) a control pulse whereof the cycle corresponds to the time interval separating the origin of the measurement period (Tf) from the first front in the given direction of the signal (S) following expiry of the measurement period.

14. Measurement device according to one of Claims 5 to 13, characterized in that the second counter (170) receives the clock signal (He) at its clock input (CLK) and receives at its reset input (RST) a control pulse whereof the cycle corresponds to the time interval separating the origin of the measurement period (Tf) from the first front in the given direction of the signal (S) following expiry of this measurement period.

15. Measurement device according to one of Claims 5 to 14, characterized in that one of the most significant digit outputs of the second counter (170) generates a signal (Z) indicating that the frequency of the input signal is below a predetermined measurement threshold.

16. Measurement device according to one of Claims 5 to 15, characterized in that storage buffers (182, 184, 192, 194) are connected to the output of the first and second counters (160, 170).

17. Measurement device according to one of Claims 5 to 16 in combination with Claim 9, characterized in that each multiplexing module (200A, 200B) is formed by an assembly of logic gates (202-298).

18. Measurement device according to one of Claims 5 to 17 in combination with Claim 9, characterized in that the storage cells (400A, 400B, 400C) adapted to store the result determined by the calculation cell are formed by flipflops (402, 404).

19. Measurement device according to one of Claims 5 to 18, characterized in that each calculation cell (300) supplies the result of the ratio between, on the one hand, the number (N) of fronts of the signal which are counted during the measurement frame (Tf) by the first counter (160) and, on the other hand, the number of clock pulses (K) counted by the second counter (170), in floating point notation in the form of a mantissa and an exponent.

20. Measurement device according to Claim 19, characterized in that it comprises at least one storage cell (400) comprising a first sub-unit (402) adapted to store the mantissa and a second sub-unit (404) adapted to store the exponent.

21. Measurement device according to one of Claims 5 to 20, characterized in that each calculation cell (300) comprises:

- a principal register (DQ, 324, 325, 326) which initially stores the dividend corresponding to the number (N) of fronts counted by the first counter (160) during the measurement period,

- an auxiliary register (AC, 315, 316, 317) preset to zero, and

- a secondary register (DR, 301-311) which initially receives the divisor corresponding to the number (K) of pulses counted at the second counter (170), the calculation cell (300) being controlled to perform the following steps:

a) offsetting by one position to the left the contents of the principal register (DQ) and of the auxiliary register (AC),

b) subtracting the contents of the secondary register (DR) from the contents of the auxiliary register (AC),

c) if the carrier digit from step b) is equal to 1, defining the least significant digit of the principal register (DQ) as equal to zero and adding the contents of the auxiliary register (AC) and the contents of the secondary register (DR), the result of the addition being used to update the auxiliary register (AC),

d) if the carrier digit from step b) is equal to zero, defining the least significant digit of the principal register (DQ) as equal to one and subtracting the contents of the secondary register (DR) from the contents of the auxiliary register (AC), the result of the subtraction being used to update the contents of the auxiliary register (AC),

e) before each addition or subtraction in steps c) and d), offsetting by one position to the left the contents of the principal register (DQ) and of the auxiliary register (AC),

f) reiterating steps b) to e) a number of times equal to n-1, n corresponding to the number of bits in the dividend (N) and the divisor (K).

22. Measurement device according to Claim 21, characterized in that, in the course of a second phase, steps a) to e) are reiterated until the most significant bit of the principal register (DQ) is equal to 1 and moreover comprising an auxiliary counter (CE) incremented with each iteration of the second phase, in which case the mantissa of the result sought is available in the principal register (DQ), while the exponent is available as output of the auxiliary counter (CE).

**Patentansprüche**

1. Verfahren zum Messen der Frequenz eines elektrischen Signals (S) der Art, welches die Verfahrensschritte umfaßt, die darin bestehen:

i) eine Meßzeit (Tf) von vorgegebener, fester Dauer zu definieren,

ii) die Fronten einer vorgegebenen Richtung, ansteigend oder fallend, des zu messenden Signals (S) festzustellen und Gattersteuerungssignale zu erzeugen, die einerseits mit der ersten Front der vorgegebenen Richtung des Signals (S) während der Meßzeit (Tf) synchronisiert sind und andererseits mit der ersten Front der gegebenen Richtung des folgenden Signals (S) nach dem Verstreichen der Meßzeit (Tf) synchronisiert sind,

iii) in einem ersten Zähler die Anzahl (N) der Fronten der gegebenen Richtung des Signals (S) zwischen der ersten Front der gegebenen Richtung des Signals (S) während der Meßzeit (Tf) und der ersten Front der gegebenen Richtung des folgenden Signals (S) nach dem Verstreichen der Meßzeit (Tf) zu zählen,

iv) ein Taktsignal (He) konstanter Frequenz zu erzeugen,

v) in einem zweiten Zähler die Anzahl (K) der Taktimpulse, die zwischen der ersten Front der gegebenen Richtung des Signale (S) während der Meßzeit (Tf) und der ersten Front der gegebenen Richtung des folgenden Signale (S) nach dem Verstreichen der Meßzeit (Tf) erzeugt werden, zu zählen, und

vi) das Verhältnis zwischen auf der einen Seite der von dem ersten Zähler gezählten Anzahl (N) von Fronten des Signals (S) und auf der anderen Seite der von des zweiten Zähler gezählten Anzahl (K) von Taktimpulsen zu bilden,

gekennzeichnet durch die Tatsache, daß die Detektion der Fronten des Signals (S) ausgewertet wird, indem der Ursprung der Meßzeit (Tf) mit einer ersten Front gegebener Richtung des Signale (S) synchronisiert wird.

2. Meßverfahren nach Anspruch 1, gekennzeichnet durch die Tatsache, daß die Periode des Taktsignals (He) ungefähr 100 mal geringer ist als die Dauer der Meßzeit (Tf).

3. Meßverfahren nach einem der Ansprüche 1 oder 2, gekennzeichnet durch die Tatsache, daß die Dauer der Meßzeit (Tf) zwischen 40 und 100 ms liegt, wobei sie vorzugsweise in der Größenordnung von 50 ms liegt.

4. Meßverfahren nach einem der Ansprüche 1 bis 3, gekennzeichnet durch die Tatsache, daß die Frequens des Signals (S) erhalten wird, indem man die Frequens des Taktsignals (He) mit dem Ergebnis des Verhältnisses zwischen auf der einen Seite der Anzahl (N) von Signalfronten, die in Schritt (ii) berechnet wurde, und auf der anderen Seite der Anzahl (K) von Taktimpulsen, die in Schritt (v) berechnet wurde, multipliziert.

5. Vorrichtung zum Messen der Frequenz eines elektrischen Signale (S) zum Ausführen des Verfahrens nach einem der Ansprüche 1 bis 4, des Typs, der umfaßt:
   - eine Anordnung (110), die eine Meßzeit (Tf) von vorgegebener, fester Dauer definiert,
   - Detektorvorrichtungen (130), die die Fronten einer vorgegebenen Richtung, ansteigend oder fallend, des zu messenden Signals (S) feststellen und Gattersteuerungssignale erzeugen, die einerseits mit der ersten Front der vorgegebenen Richtung des Signals (S) während der Meßzeit (Tf) synchronisiert sind und andererseits mit der ersten Front der gegebenen Richtung des folgenden Signals (S) nach dem Verstreichen der Meßzeit (Tf) synchronisiert sind,
   - einen ersten Zähler (160), der von den Gattersteuerungssignalen gesteuert wird und der die Anzahl (N) der Fronten der gegebenen Richtung des Signals (S) zwischen der ersten Front der gegebenen Richtung des Signals (S) während der Meßzeit (Tf) und der ersten Front der gegebenen Richtung des folgenden Signale (S) nach dem Verstreichen der Meßzeit (Tf) zählt,
   - einen Taktgeber (150), der ein Taktsignal (He) konstanter Frequenz erzeugt,
   - einen zweiten Zähler (170), der von den Gattersteuerungssignalen gesteuert wird und die Anzahl (K) der Taktimpulse, die zwischen der ersten Front der gegebenen Richtung des Signals (S) während der Meßzeit (Tf) und dar ersten Front der gegebenen Richtung des folgenden Signals (S) nach dem Verstreichen dar Meßzeit (Tf) erzeugt werden, zählt, und
   - eine Zelle (300), die geeignet ist, das Verhältnis zwischen auf der einen Seite der von dem ersten Zähler (180) gezählten Anzahl (N) von Fronten des Signals (S) und auf der anderen Seite der von dem zweiten Zähler (170) gezählten Anzahl (K) von Taktimpulsen zu bilden,
   gekennzeichnet durch die Tatsache, daß die Detektionsvorrichtungen (130), die die Fronten des Signals (S) feststellen, mit der Anordnung (110) verbunden sind, die die vorgegebene, feste Meßzeit (Tf) definieren, und auf diese Anordnung einwirken, um den Ursprung der Meßzeit (Tf) mit einer ersten Front gegebener Richtung des Signals (S) zu synchronisieren.

6. Meßvorrichtung nach Anspruch 5, gekennzeichnet durch die Tatsache, daß die Periode des Taktsignals (He) ungefähr 100 mal geringer ist als die Dauer der Meßzeit (Tf).

7. Meßvorrichtung nach einem der Ansprüche 5 oder 6, gekennzeichnet durch die Tatsache, daß die Dauer der Meßzeit (Tf) zwischen 40 und 100 ms liegt, wobei sie vorzugsweise in der Größenordnung von 50 ms liegt.

8. Meßvorrichtung nach einem der Ansprüche 5 bis 7, gekennzeichnet durch die Tatsache, daß die Periode des Taktsignals (He) in der Größenordnung von 500 $\mu$s liegt.

9. Meßvorrichtung nach einem der Ansprüche 5 bis 8, die erlaubt, die Frequenz von mehreren elektrischen Signalen zu messen, gekennzeichnet durch die Tatsache, daß sie umfaßt:
   - mehrere Verarbeitungsmodule (100A, 100B, 100C), die jeweils umfassen:
     - eine Anordnung (110), die eine Meßzeit (Tf) von vorgegebener, fester Dauer definiert,
   - Detektorvorrichtungen (130), die die Fronten einer vorgegebenen Richtung, ansteigend oder fallend, eines entsprechenden, damit verbundenen Signals (S) feststellen und Gattersteuerungssignale erzeugen, die einerseits mit der ersten Front der vorgegebenen Richtung des Signals (S) während der Meßzeit (Tf) synchronisiert sind und andererseits mit der ersten Front der gegebenen Richtung des folgenden Signals (S) nach dem Verstreichen der Meßzeit (Tf) synchronisiert sind,
   - einen ersten Zähler (160), der von den Gattersteuerungssignalen gesteuert wird und der die Anzahl (N) der Fronten der gegebenen Richtung des Signals (S) zwischen der ersten Front der gegebenen Richtung des Signals (S) während der Meßzeit (Tf) und der ersten Front der gegebenen Richtung des folgenden Signals (S) nach dem Verstreichen der Meßzeit (Tf) zählt,
   - einen Taktgeber (150), der ein Taktsignal (He) konstanter Frequenz erzeugt,
   - einen zweiten Zähler (170), der von den Gattersteuerungssignalen gesteuert wird und die Anzahl (K) der Taktimpulse, die zwischen der ersten Front der gegebenen Richtung des Signale (S) während der Meßzeit (Tf) und der ersten Front der gegebenen Richtung des folgenden Signale (S) nach dem Verstreichen der Meßzeit (Tf) erzeugt werden, zählt,

- zwei Multiplexermodule (200A, 200B), die jeweils eine Anzahl von Eingängen gleich der Anzahl von Verarbeitungsmodulen (100A, 100B, 100C) und einen einzigen Ausgang besitzen, die am Eingang einerseits Signale (VN$_1$, VN$_2$, VN$_3$) empfangen, die den Inhalt jedes der ersten Zähler darstellen, und andererseits Signale (VK$_1$, VK$_2$, VK$_3$) empfangen, die den Inhalt jedes der zweiten Zähler darstellen, um diese Signale zu multiplexen,
- eine einzige Berechnungszelle (300), die sequentiell und der Reihe nach, das Verhältnis zwischen der von dem ersten Zähler (160) gezählten Anzahl (N) und der von dem zweiten Zähler (170) gezählten Anzahl (K) jedes der Verarbeitungsmodule (100A, 100B, 100C) bildet, und
- Speicherzellen (440A, 440B, 440C) in einer Anzahl gleich der Anzahl der Verarbeitungsmodule (100A, 100B, 100C), die geeignet sind, jeweils das von der einzigen Berechnungszelle bestimmte Ergebnis, das einem damit verbundenen Signal entspricht, zu speichern.

10. Meßvorrichtung nach einem der Ansprüche 5 bis 9, gekennzeichnet durch die Tatsache, daß jede Anordnung (110) einen Zähler (113) umfaßt, der an seines Takteingang ein Basistaktsignal (H) erhält und dessen Ausgänge mit logischen Gattern (114-121) verbunden sind, die ein Signal (Tf) erzeugen, das die Meßzeit einer vorgegebenen, festen Dauer angibt.

11. Meßvorrichtung nach einem der Ansprüche 5 bis 10, gekennzeichnet durch die Tatsache, daß die Detektion der ersten Front einer vorgegebenen Richtung des Signals (S) nach dem Verstreichen der Meßzeit (Tf) durch eine Anordnung logischer Gatter (133, 134, 135, 137) und von Kippschaltungen (138, 138) durchgeführt wird.

12. Meßvorrichtung nach einem der Ansprüche 5 bis 11, gekennzeichnet durch die Tatsache, daß jeder Taktgeber (150) einen Zähler (154) umfaßt, der an seinem Takteingang ein Basistaktsignal (H) erhält und dessen Ausgänge mit logischen Gattern (155, 156, 157) verbunden sind, die am Ausging das Taktsignal (He) erzeugen.

13. Meßvorrichtung nach einem der Ansprüche 5 bis 12, gekennzeichnet durch die Tatsache, daß der erste Zähler (160) das Signal, dessen Frequenz man messen möchte, an seinem Takteingang (CLK) empfängt und an seinem Reset-Eingang (RST) einen Rechteckimpuls erhält, dessen Periode dem Zeitintervall entspricht, das den Ursprung der Meßzeit (Tf) von der ersten Front gegebener Richtung den Signals (S), die nach dem Verstreichen der Meßzeit folgt, trennt.

14. Meßvorrichtung nach einem der Ansprüche 5 bis 13, gekennzeichnet durch die Tatsache, daß der zweite Zähler (170) das Taktsignal (He) an seinem Takteingang (CLK) empfängt und an seinem Reset-Eingang (RST) einen Rechteckimpuls erhält, dessen Periode dem Zeitintervall entspricht, das den Ursprung der Meßzeit (Tf) von der ersten Front gegebener Richtung des Signals (S), die nach dem Verstreichen dieser Meßzeit folgt, trennt.

15. Meßvorrichtung nach einem der Ansprüche 6 bis 14, gekennzeichnet durch die Tatsache, daß einer der höherwertigen Ausgänge des zweiten Zählers (170) ein Signal (Z) erzeugt, das anzeigt, daß die Frequenz des Eingangssignals niedriger ist als eine vorgegebene Meßschwelle.

16. Meßvorrichtung nach einem der Ansprüche 5 bis 15, gekennzeichnet durch die Tatsache, daß Speicherpuffer (182, 184, 192, 194) an die Ausgänge der ersten und zweiten Zähler (160, 170) angeschlossen sind.

17. Meßvorrichtung nach einem der Ansprüche 5 bis 18 in Verbindung mit Anspruch 9, gekennzeichnet durch die Tatsache, daß jedes Multiplexermodul (200A, 200B) aus einer Anordnung von logischen Qattern (202, 298) gebildet ist.

18. Meßvorrichtung nach einem der Ansprüche 5 bis 17 in Verbindung mit Anspruch 9, gekennzeichnet durch die Tatsache, daß die Speicherzellen (404A, 404B, 404C), die geeignet sind, das von der Berechnungszelle bestimmte Ergebnis zu speichern, aus Kippschaltungen (402, 404) gebildet sind.

19. Meßvorrichtung nach einem der Ansprüche 5 bis 18, gekennzeichnet durch die Tatsache, daß jede Berechnungszelle (300) das Resultat des Verhältnisses von auf der einen Seite der Anzahl (N) von während des Meßfensters (Tf) von dem ersten Zähler gezählten Fronten und von auf der anderen Seite der Anzahl (K) von von dem zweiten Zähler (170) gezählten Taktimpulsen als Fließkommazahl in der Form einer Mantisse und eines Exponenten erzeugt.

20. Meßvorrichtung nach Anspruch 19, gekennzeichnet durch die Tatsache, daß sie wenigstens eine Speicherzelle (400) umfaßt, die eine erste Unteranordnung (402), die geeignet ist, die Mantisse zu speichern, und eine zweite Unteranordnung (404), die geeignet ist, den Exponenten zu speichern, umfaßt.

21. Meßvorrichtung nach einem der Ansprüche 5 bis 20, gekennzeichnet durch die Tatsache, daß jede Berechnungszelle (300) umfaßt;
    - ein Hauptregister (DQ, 324, 325, 326), das anfänglich den Dividenden speichert, der der während der Meßzeit von dem ersten Zähler (160) gezählten Anzahl (N) von Fronten entspricht,
    - ein Hilfsregister (AC, 315, 316, 317), das auf Null zurückgesetzt ist, und
    - ein sekundäres Register (DR, 301-311), das anfänglich den Divisor erhält, der der Anzahl (K) von durch den zweiten Zähler (170) gezählten Impulsen entspricht, wobei die Berechnungszelle (300) so gesteuert wird, daß sie die folgenden Schritte durchführt:
    a) Verschieben um einen Rang nach links des Inhalts des Hauptregisters (DQ) und des Hilfsregisters (AC),
    b) Abziehen des Inhalts des sekundären Registers (DR) vom Inhalt des Hilfsregisters (AC),
    c) wenn das Ergebnis des Schrittes b) gleich 1 ist, Festlegen des niederwertigsten Bits des Hauptregisters (Da) als Null und Addition des Inhaltes des Hilfsregisters (AC) und des Inhaltes des sekundären Registers (DR), wobei das Ergebnis der Addition zum Auffrischen des Hilfsregisters (AC) verwendet wird,
    d) wenn das Ergebnis des Schrittes b) gleich 0 ist, Festlegen des niederwertigsten Bits des Hauptregisters (DQ) als 1 und Subtraktion des Inhaltes des sekundären Registers (DR) vom Inhalt des Hilfsregisters (AC), wobei das Ergebnis der Subtraktion zum Auffrischen des Hilfsregisters (AC) verwendet wird,
    e) vor jeder Addition oder Subtraktion in den Schritten c) und d) Verschieben um einen Ring nach links des Inhalts des Hauptregisters (DQ) und des Hilfsregisters (AC),
    f) Wiederholen der Schritte b) bis e) mit einer Anzahl n-1, wobei n der Anzahl der Bits des Dividenden (N) und des Divisors (K) entspricht.

22. Meßvorrichtung nach Anspruch 21, gekennzeichnet durch die Tatsache, daß während einer zweiten Phase die Schritte a) bis e) wiederholt werden, bis das Bit des höchsten Gewichts des Hauptregisters (DQ) gleich 1 ist, und daß sie außerdem einen Hilfszähler (CE) umfaßt, der bei jeder Iteration der zweiten Phase inkrementiert wird, in welchem Fall die Mantisse des gesuchten Ergebnisses in dem Hauptregister (DQ) verfügbar ist, während der Exponent am Ausgang des Hilfszählers (CE) verfügbar ist.

## FIG.1

## FIG.2

FIG.1bis

SCHEMA GENERAL

FIG.3

EP 0 263 745 B1

FIG_4    CALCUL DES GRANDEURS N et K
REPRESENTATIVES DE LA FREQUENCE

27

FIG.4    CALCUL DES GRANDEURS N et K
REPRESENTATIVES DE LA FREQUENCE

FIG.5

CIRCUIT DE MULTIPLEXAGE

FIG.6    CIRCUIT DE GESTION 500

FIG.6    CIRCUIT DE
             GESTION 500

FIG.7    CIRCUIT DE SORTIE 400

# FIG.8A

600

STOCKAGE DE "0" DANS BASCULE BRES
STOCKAGE DIVIDENDE N DANS REGISTRE DQ
STOCKAGE DIVISEUR K DANS REGISTRE DR
STOCKAGE "0" DANS REGISTRE AC
RAZ D'UN COMPTEUR CE
RAZ D'UN COMPTEUR CI

602

DECALAGE A GAUCHE DES REGISTRES AC ET DQ
INCREMENT DU COMPTEUR CI = CI + 1

OUI ← CONTENU BASCULE BRES = 1 → NON

604

606

ADDITION
AC = AC + DR

608

SOUSTRACTION
AC = AC - DR

610

POIDS $2^n$ AC TRANSFERE DANS BASCULE BRES

612

POIDS LE PLUS FAIBLE DU REGISTRE DQ = $\overline{BRES}$

614

NON ← CI = n

OUI

616

EP 0 263 745 B1

FIG.8B

Flowchart FIG.8B:

614 — CI = n
- NON → 602
- OUI ↓

616 — POIDS LE PLUS FORT DU REGISTRE DQ = 1
- OUI →
- NON ↓

618 — DECALAGE A GAUCHE DES REGISTRES AC et DQ ET INCREMENT DU COMPTEUR CE = CE + 1

620 — CONTENU DE LA BASCULE BRES = 1
- OUI → 622 ADDITION AC = AC + DR
- non → 624 SOUSTRACTION AC = AC − DR

626 — POIDS $2^n$ AC TRANSFERE DANS LA BASCULE BRES

628 — POIDS LE PLUS FAIBLE DU REGISTRE DQ = $\overline{BRES}$

630 — CE = $2^n - 1$
- NON →
- OUI →

632 — FIN

34

FIG.9

CIRCUIT DIVISEUR

FIG_9  CIRCUIT DIVISEUR

36

# FIG.10

GESTION DU
CIRCUIT DIVISEUR

350

EP 0 263 745 B1